# EUROPEAN PATENT APPLICATION

(11) **EP 2 998 966 A1**
(43) Date of publication of application: **23.03.2016**
(21) Application number: 13884751.2
(22) Date of filing: 13.05.2013
(51) Int. Cl.: H01B 1/22, H01B 1/00, H01B 5/14, H01L 21/28, H01L 31/04

(54) **ELECTRODE-FORMING COMPOSITION, SOLAR-CELL ELEMENT, AND SOLAR CELL**

(71) Applicant: Hitachi Chemical Company, Ltd., Chiyoda-ku Tokyo 100-6606 (JP)
(72) Inventor: ADACHI, Shuichiro, Tsukuba-shi Ibaraki 300-4247 (JP); YOSHIDA, Masato, Tsukuba-shi Ibaraki 300-4247 (JP); NOJIRI, Takeshi, Tsukuba-shi Ibaraki 300-4247 (JP); KURATA, Yasushi, Tsukuba-shi Ibaraki 300-4247 (JP); KURIHARA, Yoshiaki, Tsukuba-shi Ibaraki 300-4247 (JP); KATO, Takahiko, Hitachi-shi Ibaraki 3191292 (JP)
(74) Representative: Hoffmann Eitle
(86) International application number: PCT/JP2013/063332
(87) International publication number: WO 2014/184856

(57) **Abstract**

A composition for forming an electrode includes a phosphorus-containing copper alloy particle, a tin-containing particle, a specific metal element M-containing particle, a glass particle, a solvent and a resin, in which M is at least one selected from the group consisting of Li, Be, Na, Mg, K, Ca, Rb, Sr, Cs, Ba, Fr, Ra, Sc, Ti, V, Cr, Mn, Fe, Co, Ni, Cu, Zn, Y, Zr, Nb, Mo, Tc, Ru, Pd, Ag, Cd, La, Ce, Pr, Nd, Pm, Sm, Eu, Gd, Tb, Dy, Ho, Er, Tm, Yb, Lu, Hf, Ta, W, Re, Os, Ir, Pt, Au, Hg, Al, Ga, Ge, In, Sb, Tl, Pb, Bi and Po.

## Description

### [Technical Field]

The present invention relates to a composition for forming an electrode, a photovoltaic cell element and a photovoltaic cell.

### [Background Art]

Generally, an electrodes is formed on each of the light receiving surface and the back surface of a silicon-base photovoltaic cell. For taking out efficiently the electrical energy converted in a photovoltaic cell from entered light, it is necessary that the volume resistivity of the electrode is sufficiently low and that the electrode forms a favorable ohmic contact with a silicon substrate. Especially, with respect to the electrode on the light receiving surface, the aspect ratio of the electrode tends to be selected high by decreasing the wiring width, from a viewpoint of limiting the loss in the incoming solar light quantity as low as possible.

The electrode on the light receiving surface of a photovoltaic cell is formed ordinarily as follows. Namely, a texture (concavo-convex shape) is formed on the light receiving surface of a p-type silicon substrate, then a n-type diffusion layer is formed thereon by diffusing phosphorus or the like thermally at a high temperature, and an electrically conductive composition is applied thereto by screen printing or the like, which is then thermal-treated (sintered) in the air at from 800°C to 900°C to form an electrode on the light receiving surface. The electrically conductive composition for forming an electrode on the light receiving surface contains an electrically conductive metal particle, a glass particle, various additives and the like.

As the electrically conductive metal particle, a silver particle is generally used. The reasons behind this include that the volume resistivity of a silver particle is as low as 1.6×10⁻⁶ S2·cm, that the silver particles are sintered through self reduction under the heat treatment (sintering) condition, that a favorable ohmic contact with a silicon substrate can be formed, and that an electrode formed of a silver particle is superior in wettability of a solder material enabling a wiring material (tab line or the like) for connecting photovoltaic cell elements electrically to be bonded favorably.

As described above, an electrode formed of an electrically conductive composition containing a silver particle exhibits superior characteristics as a photovoltaic cell electrode. On the other hand, silver is a noble metal, and a raw metal itself of the same is expensive, and further in view of constraint on resources, an electroconductive material replacing silver has been demanded. Copper is a promising candidate of an electroconductive material replacing silver, which has been utilized as a wiring material for a semiconductor. There have been abundant resources of copper, and the raw metal price of the same is inexpensive and approximately 1/100 of the same of silver. However, copper is a material that is easily oxidized in the air at a temperature of 200°C or higher, and therefore an electrode is hardly produced therefrom by the above process.

To cope with the drawback of copper, copper particles which are hardly oxidized during a high temperature heat treatment (sintering) through impartation of oxidation resistance to copper by various techniques have been reported (see, for example, refer to Patent Document 1 and Patent Document 2).

### [Prior Art Document]

### [Patent Document]

[Patent Document 1] Japanese Patent Application Laid-Open (JP-A) No. 2005-314755
[Patent Document 2] JP-A No. 2004-217952

### SUMMARY OF INVENTION

### [Technical Problem]

However, the oxidation resistance of the copper particles of both Patent Document 1 and Patent Document 2 is at best up to 300°C, and they are almost completely oxidized at a high temperature of from 800°C to 900°C, and therefore an electrode formed of the copper particles has been not yet put to practical use as a photovoltaic cell electrode. Moreover there has been a drawback in that an additive or the like utilized for imparting oxidation resistance obstructs sintering of copper particles during a heat treatment (sintering) and as the result an electrode with such low resistance as silver cannot be obtained.

There has been also a special process as another technique for suppressing oxidation of copper, in which an electrically conductive composition including copper as an electrically conductive metal particle is thermal-treated (sintered) in a nitrogen atmosphere or the like. However, when the technique is applied, an environment sealed hermetically with the atmospheric gas is required for suppressing completely oxidation of a copper particle, which is not suitable for large-scale production of a photovoltaic cell element in terms of a production cost.

Another problem for utilizing copper for a photovoltaic cell electrode is ohmic contact characteristics with a silicon substrate. Namely, even in an case in which a copper-containing electrode should have been formed without being oxidized during a high temperature thermal treatment (sintering), when copper contacts a silicon substrate, interdiffusion of copper and silicon may take place and a reaction product phase of copper and silicon (Cu₃Si) may be occasionally formed at an interface between the electrode and the silicon substrate.

The formed Cu₃Si may occasionally penetrate to a depth of several µm from the interface of the silicon substrate, which may cause a crack in the silicon substrate. Further, the Cu₃Si may occasionally penetrate through a n-type diffusion layer formed in advance on the silicon substrate to deteriorate the semiconductor performance (pn junction characteristics) of a photovoltaic cell. Further, there has been a risk that the formed Cu₃Si may raise a copper-containing electrode or otherwise to obstruct adherence between the electrode and the silicon substrate and to decrease the mechanical strength of the electrode.

The present invention was made in view of the above-described problems with an object to provide a composition for forming an electrode, the composition which can form an electrode with a low resistivity, and also a copper-containing electrode having a favorable ohmic contact with a silicon substrate, a photovoltaic cell element having an electrode formed with the composition for forming an electrode, and a photovoltaic cell.

### [Solution to Problem]

In order to solve the above-described problems, the inventor studied diligently, and as the result the present invention was completed. Namely, the present invention is as follows.
<1> A composition for forming an electrode, the composition including a phosphorus-containing copper alloy particle, a tin-containing particle, a specific metal element M-containing particle, a glass particle, a solvent and a resin, in which M represents at least one selected from the group consisting of Li, Be, Na, Mg, K, Ca, Rb, Sr, Cs, Ba, Fr, Ra, Sc, Ti, V, Cr, Mn, Fe, Co, Ni, Cu, Zn, Y, Zr, Nb, Mo, Tc, Ru, Pd, Ag, Cd, La, Ce, Pr, Nd, Pm, Sm, Eu, Gd, Tb, Dy, Ho, Er, Tm, Yb, Lu, Hf, Ta, W, Re, Os, Ir, Pt, Au, Hg, Al, Ga, Ge, In, Sb, Tl, Pb, Bi and Po.
<2> The composition for forming an electrode according to <1>, in which a phosphorus content in the phosphorus-containing copper alloy particle is from 6.0% by mass to 8.0% by mass.
<3> The composition for forming an electrode according to <1> or <2>, in which the tin-containing particle is at least one selected from the group consisting of a tin particle, and a tin alloy particle in which a content of tin is 1% by mass or more.
<4> The composition for forming an electrode according to any one of <1> to <3>, in which the specific metal element M-containing particle is at least one selected from the group consisting of a particle of the specific metal element M, and an alloy particle of the specific metal element M in which a content of the specific metal element M is 5% by mass or more.
<5> The composition for forming an electrode according to any one of <1> to <4>, in which a softening point of the glass particle is 650°C or less, and a crystallization initiation temperature of the glass particle is greater than 650°C.
<6> The composition for forming an electrode according to any one of <1> to <5>, in which a content of the tin-containing particle is from 5% by mass to 70% by mass when a total content of the phosphorus-containing copper alloy particle, the tin-containing particle, and the specific metal element M-containing particle is designated as 100% by mass.
<7> The composition for forming an electrode according to any one of <1> to <6>, in which a content of the specific metal element M-containing particle is from 5% by mass to 70% by mass when a total content of the phosphorus-containing copper alloy particle, the tin-containing particle, and the specific metal element M-containing particle is designated as 100% by mass.
<8> The composition for forming an electrode according to any one of <1> to <7>, in which a total content of the phosphorus-containing copper alloy particle, the tin-containing particle, and the specific metal element M-containing particle is from 70% by mass to 94% by mass, a content of the glass particle is from 0.1 % by mass to 10% by mass, and a total content of the solvent and the resin is from 3% by mass to 29.9% by mass.
<9> A photovoltaic cell element having a silicon substrate, and an electrode which is a thermal-treated product of the composition for forming an electrode according to any one of <1> to <8> provided on the silicon substrate.
<10> The photovoltaic cell element according to <9>, in which the electrode comprises an alloy phase containing Cu and Sn and a glass phase containing Sn, P and O.
<11> The photovoltaic cell element according to <10>, in which the glass phase is placed between the alloy phase and the silicon substrate.
<12> A photovoltaic cell having the photovoltaic cell element according to any one of <9> to <11>, and a wiring material placed on the electrode of the photovoltaic cell element.

### [Advantageous Effects of Invention]

The present invention can provide a composition for forming an electrode, the composition which can form an electrode with a low resistivity, and also a copper-containing electrode having a favorable ohmic contact with a silicon substrate, photovoltaic cell element having an electrode formed with the composition for forming an electrode, and a photovoltaic cell.

### BRIEF DESCRIPTION OF DRAWINGS

Fig. 1 is a schematic cross-sectional view showing an example of a photovoltaic cell element.
Fig. 2 is a schematic plan view showing an example of the light receiving surface of a photovoltaic cell element.
Fig. 3 is a schematic plan view showing an example of the back surface of a photovoltaic cell element.
Fig. 4 is a schematic plan view showing an example of an electrode structure on the back surface of a back contact photovoltaic cell element.
Fig. 5 is a schematic perspective view showing an example of a cross-sectional structure along A-A of a back contact photovoltaic cell element.
Fig. 6 is a schematic perspective view showing another example of a cross-sectional structure along A-A of a back contact photovoltaic cell element.
Fig. 7 is a schematic perspective view showing still another example of a cross-sectional structure along A-A of a back contact photovoltaic cell element.

### DESCRIPTION OF EMBODIMENTS

In the present specification, the term "process" denotes not only independent processes but also processes that cannot be clearly distinguished from other processes as long as a purpose is accomplished by the process. Meanwhile, in the present specification, "from...to..." denotes a range including each of the minimum value and the maximum value of the values described in this expression. Further, in the present specification, when there exist plural corresponding substances for each component in the composition, the amount of each component in the composition refers to the total amount of the plural substances plural substances in the composition, unless otherwise specified. Further, in the present specification, the term "layer" comprehends herein not only a structure formed over the whole surface when observed as a plan view, but also a structure formed only on a part of the same.

### <Composition for forming electrode>

A composition for forming an electrode in the present invention contains at least one kind of phosphorus-containing copper alloy particle, at least one kind of tin-containing particle, at least one kind of specific metal element M-containing particle (hereinafter also referred to as "specific metal M-containing particle"), at least one kind of glass particle, at least one kind of solvent, and at least one kind of resin. In this regard, M represents at least one selected from the group consisting of Li, Be, Na, Mg, K, Ca, Rb, Sr, Cs, Ba, Fr, Ra, Sc, Ti, V, Cr, Mn, Fe, Co, Ni, Cu, Zn, Y, Zr, Nb, Mo, Tc, Ru, Pd, Ag, Cd, La, Ce, Pr, Nd, Pm, Sm, Eu, Gd, Tb, Dy, Ho, Er, Tm, Yb, Lu, Hf, Ta, W, Re, Os, Ir, Pt, Au, Hg, Al, Ga, Ge, In, Sb, Tl, Pb, Bi and Po. Among them, the specific metal element M is further more preferably at least one selected from the group consisting of Ni, Mn, Ag, Ca, Mg, Bi, Cu, Mo, Au, W, Zn, Ta, Nb and Pt from viewpoints of the resistivity of an electrode, and oxidation resistance during a thermal treatment (sintering). The specific metal element M may be also at least one selected from the group consisting of Mn, Ag, Ca, Mg, Bi, Cu, Mo, Au, W, Zn, Ta, Nb and Pt, or may be also at least one selected from the group consisting of Mn, Ag, Ca, Mg, Bi, Mo, Au, W, Ta, Nb and Pt.

In a case in which a composition for forming an electrode is composed as above, oxidation of copper during a thermal treatment (sintering) in the air can be suppressed, so that an electrode with a lower resistivity can be formed. Further, when an electrode is formed by applying a composition for forming an electrode to a silicon substrate, formation of a reaction product phase of copper and silicon is suppressed, so that a favorable ohmic contact between the electrode formed and the silicon substrate can be formed. The possible reason for this is as follows.

When the composition for forming an electrode is subjected to a thermal treatment (sintering) in the air, a Cu-Sn alloy phase and a Sn-P-O glass phase are formed through a reaction of a phosphorus-containing copper alloy particle and a tin-containing particle. Owing to formation of a Cu-Sn alloy phase, an electrode with a low resistivity can be formed. In this connection, since a Cu-Sn alloy phase can be formed at a relatively low temperature of approximately 500°C, a thermal treatment (sintering) for forming an electrode can be performed at a lower temperature, and an advantage of reduction of the production cost can be expected.

A composition for forming an electrode contains further a specific metal M-containing particle. By this means, the resistivity of an electrode to be formed through a thermal treatment (sintering) can be reduced further, and an electrode with low resistance can be formed while maintaining resistance to oxidation even in a thermal treatment (sintering) process at a higher temperature. The possible reason for this is as follows.

When the specific metal element M is at least one selected from the group consisting of Li, Be, Na, Mg, K, Ca Rb, Sr, Cs, Ba, Fr, Ra, Sc, Ti, V, Cr, Mn. Fe, Co. Ni, Cu, Zn, Y Zr, Nb, Mo, Tc, Ru, Pd, Ag, Cd, La, Ce, Pr, Nd, Pm, Sm, Eu, Gd, Tb, Dy, Ho, Er, Tm, Yb, Lu, Hf, Ta, W, Re, Os, Ir, Pt, Au, Hg, Al, Ga, Ge, In, Sb, Tl, Pb, Bi, and Po, a Sn-P-O glass phase, formed through a reaction of a phosphorus-containing copper alloy particle and a tin-containing particle, reacts with a specific metal M-containing particle, so that the specific metal element M is engaged in a network of the glass phase and allowed to migrate in the glass phase. As the result, the electric conductivity of the Sn-P-O glass phase is enhanced, and the resistivity of an electrode as a whole can be conceivably lowered.

The specific metal element M may be also at least one selected from the group consisting of Li, Be, Na, Mg, K, Ca, Rb, Sr, Cs, Ba, Fr, Ra, Sc, Ti, V, Cr, Mn, Fe, Co, Cu, Zn, Y, Zr, Nb, Mo, Tc, Ru, Pd, Ag, Cd, La, Ce, Pr, Nd, Pm, Sm, Eu, Gd, Tb, Dy, Ho, Er, Tm, Yb, Lu, Hf, Ta, W, Re, Os, Ir, Pt, Au, Hg, Al, Ga, Ge, In, Sb, Tl, Pb, Bi, and Po. Further, the specific metal element M may be also at least one selected from the group consisting of Li, Be, Na, Mg, K, Ca, Rb, Sr, Cs, Ba, Fr, Ra, Sc, Ti, V, Cr, Mn, Fe, Co, Y, Zr, Nb, Mo, Tc, Ru, Pd, Ag, Cd, La, Ce, Pr, Nd, Pm, Sm, Eu, Gd, Tb, Dy, Ho, Er, Tm, Yb, Lu, Hf, Ta, W, Re, Os, Ir, Pt, Au, Hg, Al, Ga, Ge, In, Sb, Tl, Pb, Bi, and Po.

Further, it is conceivable that a Cu-Sn-M alloy phase is formed by a reaction between a Cu-Sn alloy phase, which is formed by a reaction between a phosphorus-containing copper alloy particle and a tin-containing particle, and a specific metal M-containing particle (provided that M is other than Cu). The Cu-Sn-Malloy phase may be occasionally formed even at a high temperature of 500°C or higher (for example, 800°C). Consequently, it becomes possible to select a temperature condition of a thermal treatment (sintering) for forming an electrode variously from a low temperature to a high temperature. Therefore, it is conceivable that a composition for forming an electrode in the present invention may be advantageously used as an electrode material for photovoltaic cells with a wide range of structures as described below.

A Cu-Sn-M alloy phase forms a dense bulk body in an electrode among Cu-Sn-M alloy phases themselves, or together with a Cu-Sn alloy phase to be further formed depending on a thermal treatment (sintering) condition. When the bulk body functions as an electroconductive layer, a lower resistivity of an electrode can be achieved. It is believed that coexistence of a Cu-Sn alloy phase and a Cu-Sn-M alloy phase in an electrode does not interfere with reduction of the resistivity. A dense bulk body means herein a three-dimensionally continuous structure formed with a massive Cu-Sn alloy phase and a massive Cu-Sn-M alloy phase contacted each other tightly. Existence of such a structure can be confirmed by observation of an optional cross-section perpendicular to a surface, on which an electrode is formed, of a substrate with the formed electrode using a scanning electron microscope (for example, TM-1000 Model scanning electron microscope, produced by Hitachi High-Technologies Corp.) at a magnification of from 100-fold to 10,000-fold. In this regard, the cross-section for observation is a cross-section cut by a diamond cutter RCO-961 Model produced by Refine Tec Ltd., or the like. Since there may remain a cutting mark and the like from a cutting machine on a cross-section for observation after cutting, it is preferable to polish the same with an abrasive paper or the like to remove surface indents on a cross-section for observation, and more preferable to mirror polish further the same with a buffing wheel or the like.

When an electrode is formed on a substrate containing silicon (hereinafter also referred to simply as "silicon substrate") using a composition for forming an electrode, an electrode having high adherence to a silicon substrate can be formed, and further a favorable ohmic contact between an electrode and a silicon substrate can be established. The possible reason for this is as follows.

A phosphorus-containing copper alloy particle, a tin-containing particle, and a specific metal M-containing particle react each other in a thermal treatment (sintering) process to form an electrode containing a Cu-Sn-M alloy phase, a Sn-P-O glass phase, and a Cu-Sn alloy phase to be formed depending on a thermal treatment (sintering) condition. Since a Cu-Sn-M alloy phase and a Cu-Sn alloy phase to be formed depending on a thermal treatment (sintering) condition are dense bulk bodies, a Sn-P-O glass phase is formed between a Cu-Sn-M alloy phase and a silicon substrate, or between a Cu-Sn-M alloy phase and Cu-Sn alloy phase and a silicon substrate. This can conceivably enhance the adherence of a Cu-Sn-M alloy phase and a Cu-Sn alloy phase to a silicon substrate.

Since a Sn-P-O glass phase functions as a barrier layer for inhibiting interdiffusion of copper and silicon, it is conceivable that a favorable ohmic contact can be formed between an electrode formed by a thermal treatment (sintering) and a silicon substrate. In other words, a favorable ohmic contact can be developed between an electrode and a silicon substrate by using a composition for forming an electrode, while maintaining the adherence of the formed electrode to a silicon substrate, and without deteriorating the semiconductor performance (for example, pn junction characteristics), conceivably because a reaction between copper and silicon is suppressed to suppress formation of a reaction product phase (Cu₃Si).

Meanwhile, when Cu is contained as a specific metal element M, oxidation of the Cu can be suppressed, and a lower resistivity of an electrode to be formed can be attained. This is conceivably because a phosphorus-containing copper alloy particle is contained in a composition for forming an electrode, and a reduction action of the phosphorus prevents the Cu as a specific metal element M from oxidizing.

In other words, an electrode superior in oxidation resistance and having a low volume resistivity is formed utilizing a reducing character of a phosphorus atom in a phosphorus-containing copper alloy particle on a copper oxide by combining a tin-containing particle and a specific metal M-containing particle with a phosphorus-containing copper alloy particle in a composition for forming an electrode. When a specific metal M-containing particle reacts with a Sn-P-O glass phase out of a Sn-P-O glass phase and a Cu-Sn alloy phase formed by a reaction between a phosphorus-containing copper alloy particle and a tin-containing particle, the electric conductivity of a glass phase is improved due to engagement of a specific metal element M in a Sn-P-O glass phase network. Meanwhile, when a Cu-Sn alloy phase reacts with a specific metal M-containing particle, electroconductive layers of a Cu-Sn-M alloy phase and a Cu-Sn alloy phase to be formed depending on a thermal treatment (sintering) condition, and a Sn-P-O glass phase are formed while maintaining the volume resistivity of an electrode to be formed low. Then, a characteristic mechanism, that a favorable ohmic contact between an electrode and a silicon substrate is formed by suppressing formation of a reaction product phase between an electrode and a silicon substrate, can be conceivably attained in a series of thermal treatment (sintering) processes, for example, because a Sn-P-O glass phase functions as a barrier layer for preventing interdiffusion of copper and silicon.

Such an effect appears generally, insofar as an electrode is formed on a silicon-containing substrate using a composition for forming an electrode in the present invention, and there is no particular restriction on the kind of a silicon-containing substrate. Examples of a silicon-containing substrate include a silicon substrate for forming a photovoltaic cell, and a silicon substrate for producing a semiconductor device other than a photovoltaic cell.

### (Phosphorus-containing copper alloy particle)

A composition for forming an electrode contains at least one kind of phosphorus-containing copper alloy particle. As a phosphorus-containing copper alloy, a brazing filler material called as a copper phosphorus brazing filler metal (phosphorus concentration: approximately 7% by mass or less) has been known. A copper phosphorus brazing filler metal is also used as a bonding material between copper and copper. By using a phosphorus-containing copper alloy particle in a composition for forming an electrode, a reducing character of phosphorus on a copper oxide can be utilized to form an electrode with superior oxidation resistance and a low volume resistivity. Further, a thermal treatment (sintering) in forming an electrode can be performed at a lower temperature, so that the production cost can be advantageously reduced.

From viewpoints of oxidation resistance and reduction of the resistivity of an electrode to be formed, the phosphorus content in a phosphorus-containing copper alloy particle is preferably from 6.0% by mass to 8.0% by mass, more preferably from 6.3% by mass to 7.8% by mass, and further preferably from 6.5% by mass to 7.5% by mass. When the phosphorus content is 8.0% by mass or less, the resistivity of an electrode to be formed tends to become lower, and the productivity of a phosphorus-containing copper alloy particle is superior. Meanwhile, when the phosphorus content is 6.0% by mass or more, the oxidation resistance tends to be further superior.

A phosphorus-containing copper alloy particle contains copper and phosphorus, and may further contain another atom. Examples of another atom include Ag, Mn, Sb, Si, K, Na, Li, Ba, Sr, Ca, Mg, Be, Zn, Pb, Cd, Tl, V, Sn, Al, Zr, W, Mo, Ti, Co, Ni, and Au.

A content of another atom contained in a phosphorus-containing copper alloy particle may be, for example, 3% by mass or less in the phosphorus-containing copper alloy particle, and preferably 1% by mass or less from viewpoints of oxidation resistance and reduction of resistivity.

A phosphorus-containing copper alloy particle may be used singly, or two or more kinds thereof may be used in a combination.

There is no particular restriction on the particle diameter of a phosphorus-containing copper alloy particle. The particle diameter in a particle size distribution, at which the weight cumulated from the smaller particle diameter side reaches 50% (hereinafter occasionally abbreviated as "D50%") is preferably from 0.4 µm to 10 µm, and more preferably from 1 µm to 7 µm. When the D50% of a phosphorus-containing copper alloy particle is 0.4 µm or more, the oxidation resistance tends to be improved more effectively. When the D50% of a phosphorus-containing copper alloy particle is 10 µm or less, the contact area in an electrode between phosphorus-containing copper alloy particles themselves, or between the same and a tin-containing particle described below or a specific metal M-containing particle becomes larger, and the resistivity of an electrode tends to decrease more effectively.

In this regard, a particle diameter of a phosphorus-containing copper alloy particle is measured by a laser diffraction particle size distribution analyzer (for example, LS 13 320 Model laser scattering diffraction particle size distribution analyzer, produced by Beckman Coulter, Inc.). Specifically, a phosphorus-containing copper alloy particle is added in a range of from 0.01% by mass to 0.3% by mass in 125 g of a solvent (terpineol) to prepare a dispersion liquid. Approximately 100 mL of the dispersion liquid is injected in a cell and then measured at 25°C. The particle size distribution is measured assuming the refractive index of the solvent at 1.48.

There is no particular restriction on the shape of a phosphorus-containing copper alloy particle, and it may be any of nearly spherical, flat, blockish, platy, scaly or the like. From viewpoints of oxidation resistance and reduction of resistivity, the shape of a phosphorus-containing copper alloy particle is preferably nearly spherical, flat or platy.

There is no particular restriction on a content of a phosphorus-containing copper alloy particle in a composition for forming an electrode. The content of a phosphorus-containing copper alloy particle in a composition for forming an electrode is preferably from 15% by mass to 75% by mass from a viewpoint of reduction of the resistivity of an electrode to be formed, more preferably from 18% by mass to 70% by mass, and further preferably from 20% by mass to 65% by mass.

A phosphorus-containing copper alloy can be produced by a method used ordinarily. A phosphorus-containing copper alloy particle can be prepared using a phosphorus-containing copper alloy, which is prepared so as to be a desired content of phosphorus, by an ordinary method for preparing a metal powder. For example, a phosphorus-containing copper alloy can be produced by a water atomization method in the usual manner. The details of a water atomization method may be referred to descriptions of Metal Manual (Kinzoku Benran) (The publishing division of Maruzen Co., Ltd.) or the like.

Specifically, a phosphorus-containing copper alloy is dissolved and sprayed through a nozzle to be pulverized, and the obtained powder is dried, and classified to yield a desired phosphorus-containing copper alloy particle. In this regard, by selecting appropriate classification conditions, a phosphorus-containing copper alloy particle having a desired particle diameter can be yielded.

### (Tin-containing particle)

A composition for forming an electrode contains at least one kind of tin-containing particle. By containing a tin-containing particle, an electrode with a low resistivity can be formed.

There is no particular restriction on a tin-containing particle, insofar as it is a particle containing tin. Among others, a tin-containing particle is preferably at least one selected from the group consisting of a tin particle and a tin alloy particle, and more preferably at least one selected from the group consisting of a tin particle and a tin alloy particle whose tin content is 1% by mass or more.

There is no particular restriction on the purity of tin in a tin particle. For example, the purity of a tin particle may be 95% by mass or more, preferably 97% by mass or more, and more preferably 99% by mass or more.

There is no particular restriction on the kind of a tin alloy particle, insofar as it is an alloy particle containing tin. From viewpoints of the melting point of a tin alloy particle, and reactivity with a phosphorus-containing copper alloy particle and a specific metal M-containing particle, the tin content in a tin alloy particle is preferably 1 % by mass or more, more preferably 3% by mass or more, further preferably 5% by mass or more, and further more preferably 10% by mass or more.

Examples of a material for a tin alloy particle include a Sn-Ag alloy, a Sn-Cu alloy, a Sn-Ag-Cu alloy, a Sn-Ag-Sb alloy, a Sn-Ag-Sb-Zn alloy, a Sn-Ag-Cu-Zn alloy, a Sn-Ag-Cu-Sb alloy, a Sn-Ag-Bi alloy, a Sn-Bi alloy, a Sn-Ag-Cu-Bi alloy, a Sn-Ag-In-Bi alloy, a Sn-Sb alloy, a Sn-Bi-Cu alloy, a Sn-Bi-Cu-Zn alloy, a Sn-Bi-Zn alloy, a Sn-Bi-Sb-Zn alloy, a Sn-Zn alloy, a Sn-In alloy, a Sn-Zn-In alloy, and a Sn-Pb alloy.

Among the materials for a tin alloy particle, especially tin alloy particles, such as Sn-3.5Ag, Sn-0.7Cu, Sn-3.2Ag-0.5Cu, Sn-4Ag-0.5Cu, Sn-2.5Ag-0.8Cu-0.5Sb, Sn-2Ag-7.5Bi, Sn-3Ag-5Bi, Sn-58Bi, Sn-3.5Ag-3In-0.5Bi, Sn-3Bi-8Zn, Sn-9Zn, Sn-52In, and Sn-40Pb, are preferable. A tin alloy particle composed of any of such materials has a melting point the same as the melting point of Sn (232°C) or lower than the same. Therefore there is an advantage that the tin alloy particle melts at an early stage of a thermal treatment (sintering) to cover a surface of a phosphorus-containing copper alloy particle, and enabling the same to react more uniformly with the phosphorus-containing copper alloy particle.

With respect to the expressions concerning tin alloy particles, for example, in the case of Sn-AX-BY-CZ, this means that a content of an element X in a tin alloy particle is A% by mass, a content of an element Y is B% by mass, and a content of an element Z is C% by mass.

The tin-containing particles may be used singly or in a combination of two or more kinds.

A tin-containing particle may contain another atom, which may get mixed inevitably. Examples of another atom, which may get mixed inevitably, include Ag, Mn, Sb, Si, K, Na, Li, Ba, Sr, Ca, Mg, Be, Zn, Pb, Cd, Tl, V, Al, Zr, W, Mo, Ti, Co, Ni, and Au.

A content of another atom contained in a tin-containing particle may be, for example, 3% by mass or less in the tin-containing particle, and is preferably 1% by mass or less from viewpoints of the melting point and the reactivity with a phosphorus-containing copper alloy particle.

There is no particular restriction on the particle diameter of a tin-containing particle. The D50% of a tin-containing particle is preferably from 0.5 µm to 20 µm, more preferably from 1 µm to 15 µm, and further preferably from 5 µm to 15 µm, When the D50% of a tin-containing particle is 0.5 µm or more, the oxidation resistance of a tin-containing particle itself tends to be improved. When the D50% of a tin-containing particle is 20 µm or less, the contact area with a phosphorus-containing copper alloy particle and a specific metal M-containing particle in an electrode becomes larger and the reaction during a thermal treatment (sintering) tends to progress effectively.

In this regard, the D50% of a tin-containing particle is measured similarly as in the case of a phosphorus-containing copper alloy particle.

There is no particular restriction on the shape of a tin-containing particle, and it may be any of nearly spherical, flat, blockish, platy, scaly or the like. From viewpoints of oxidation resistance and reduction of resistivity, the shape of a tin-containing particle is preferably nearly spherical, flat or platy.

There is no particular restriction on a content of a tin-containing particle in a composition for forming an electrode. Among others, the content of a tin-containing particle is preferably from 5% by mass to 70% by mass with respect to a total content of a phosphorus-containing copper alloy particle, a tin-containing particle and a specific metal M-containing particle as 100% by mass, more preferably from 7% by mass to 65% by mass, further preferably from 9% by mass to 60% by mass, and further more preferably from 9% by mass to 45% by mass.

When the content of a tin-containing particle is 5% by mass or more, the reaction with a phosphorus-containing copper alloy particle and a specific metal M-containing particle can occur more uniformly. When the content of a tin-containing particle is 70% by mass or less, sufficient volumes of a Cu-Sn-M alloy phase and a Cu-Sn alloy phase to be formed depending on thermal treatment (sintering) conditions can be formed, and the volume resistivity of a formed electrode can further decrease.

### (Specific metal M-containing particle)

A composition for forming an electrode contains at least one kind of a specific metal element M-containing particle (specific metal M-containing particle). In this regard, the specific metal element M represents at least one selected from the group consisting of Li, Be, Na, Mg, K, Ca, Rb, Sr, Cs, Ba, Fr, Ra, Sc, Ti, V, Cr, Mn, Fe, Co, Ni, Cu, Zn, Y, Zr, Nb, Mo, Tc, Ru, Pd, Ag, Cd, La, Ce, Pr, Nd, Pm, Sm, Eu, Gd, Tb, Dy, Ho, Er, Tm, Yb, Lu, Hf, Ta, W, Re, Os, Ir, Pt, Au, Hg, Al, Ga, Ge, In, Sb, Tl, Pb, Bi, and Po. In a case in which a composition for forming an electrode contains a specific metal M-containing particle in addition to a phosphorus-containing copper alloy particle and a tin-containing particle, the resistivity of a Sn-P-O glass phase in an electrode to be formed is reduced, or the oxidation resistance at a higher temperature can be manifested at a thermal treatment (sintering) process. The specific metal M-containing particles may be used singly or in a combination of two or more kinds.

A specific metal M-containing particle in the present invention is defined as a particle other than the phosphorus-containing copper alloy particle and the tin-containing particle.

A specific metal M-containing particle is a particle containing preferably 5% by mass or more of a specific metal element M, more preferably 7% by mass or more, and further preferably 10% by mass or more.

A specific metal M-containing particle is preferably at least one selected from the group consisting of a particle composed of a specific metal element M and a particle of an alloy of a specific metal element M, and more preferably at least one selected from the group consisting of a particle composed of a specific metal element M and a particle of an alloy of a specific metal element M, in which a content of a specific metal element M is 5% by mass or more.

A specific metal element M is preferably at least one selected from the group consisting of Li, Na, K, Mg, Ca, Sr, Ba, Ti, Mn, Co, Ni, Cu, Zn, Zr, Mo, Ag, W, Pt, Au, Al, Pb and Bi from viewpoints of the reactivity with a Sn-P-O glass phase and the reactivity with a Cu-Sn alloy phase, and may be also at least one selected from the group consisting of Li, Na, K, Mg, Ca, Sr, Ba, Ti, Mn, Co, Cu, Zn, Zr, Mo, Ag, W, Pt, Au, Al, Pb and Bi, or at least one selected from the group consisting of Li, Na, K, Mg, Ca, Sr, Ba, Ti, Mn, Co, Zr, Mo, Ag, W, Pt, Au, Al, Pb and Bi. A specific metal element M is more preferably at least one selected from the group consisting of Na, K, Mg, Ca, Ba, Mn, Co, Ni, Cu, Mo, Ag, W, Au, Al, Pb and Bi, or at least one selected from the group consisting of Na, K, Mg, Ca, Ba, Mn, Co, Cu, Mo, Ag, W, Au, Al, Pb and Bi, or at least one selected from the group consisting of Na, K, Mg, Ca, Ba, Mn, Co, Mo, Ag, W, Au, Al, Pb and Bi.

Further, from a viewpoint of reduction of the resistivity of an electrode to be formed by a thermal treatment (sintering), a specific metal M-containing particle is further more preferably a particle composed of at least one selected from the group consisting of Ni, Mn, Ag, Ca, Mg, Bi, Cu, Mo, Au, W, Al, a Ni-Cu alloy, a Ni-Cu-Zn alloy, a Cu-Bi alloy, a Cu-Ag alloy, and a Cu-Zn alloy.

The purity of a specific metal element M in a particle composed of a specific metal element M may be for example, 95% by mass or more, preferably 97% by mass or more, and more preferably 99% by mass or more.

With respect to an alloy particle of a specific metal element M, there is no particular restriction on the kind of an alloy, insofar as it is an alloy particle containing a specific metal element M. An alloy containing two or more kinds of specific metal elements M may be also used. A content of a specific metal element M in an alloy particle of a specific metal element M (when two or more kinds of specific metal elements M are used in combination, it means a total content thereof) may be, for example, 5% by mass or more, preferably 7% by mass or more, and more preferably 10% by mass or more.

Among specific metal elements M, as elements for reducing the resistivity of a Sn-P-O glass phase in an electrode to be formed, use of an alkali metal, and an alkaline earth metal is preferable from a viewpoint of the reactivity with a Sn-P-O glass phase. Specifically, use of at least one selected from the group consisting of Li, Na, K, Mg, Ca, Sr and Ba is preferable, and use of at least one selected from the group consisting of Na, K, Mg, Ca and Ba is more preferable.

Among specific metal elements M, as elements for developing oxidation resistance at a high temperature and for reacting with a Cu-Sn alloy phase, use of a metal other than an alkali metal and an alkaline earth metal is preferable from viewpoints of the reactivity with a Cu-Sn alloy phase and the melting point. Specifically, use of at least one selected from the group consisting of Ti, Mn, Co, Ni, Cu, Zn, Zr, Mo, Ag, Pt, Au, Al, Pb and Bi is preferable, and use of at least one selected from the group consisting of Mn, Co, Ni, Cu, Mo, Ag, W, Au, Pb and Bi is more preferable.

Examples of an alloy particle of a specific metal element M include particles of a Cu-Sn alloy, a Cu-Zn alloy, a Cu-Au alloy, an Fe-Co alloy, an Fe-Mn alloy, a Ni-Fe alloy, a Ni-Cu alloy, a Ni-Cu-Zn alloy, a Ni-Cr alloy, and a Ni-Cr-Ag alloy. Especially, a nickel alloy particle such as Ni-58Fe, Ni-60Cu and Ni-6Cu-20Zn can be used favorably from a viewpoint that the particle can react more uniformly with a phosphorus-containing copper alloy particle and a tin-containing particle. With respect to the expressions concerning an alloy particle of a specific metal element M, for example, in the case of Ni-AX-BY-CZ, this means that a content of an element X in a nickel alloy particle is A% by mass, a content of an element Y is B% by mass, and a content of an element Z is C% by mass.

A specific metal M-containing particle may contain another atom, which may get mixed inevitably. Examples of another atom, which may get mixed inevitably, include Si, B, P, C, N, O, F, S, Cl and H. A content of another atom contained in a specific metal M-containing particle may be, for example, 3% by mass or less in the specific metal M-containing particle, and preferably 1% by mass or less.

There is no particular restriction on the particle diameter of a specific metal M-containing particle. The D50% of a specific metal M-containing particle is preferably from 0.5 µm to 20 µm, more preferably from 1 µm to 15 µm, and further preferably from 1.5 µm to 15 µm, When the D50% of a specific metal M-containing particle is 0.5 µm or more, the oxidation resistance of a specific metal M-containing particle itself tends to be improved. When the D50% of a specific metal M-containing particle is 20 µm or less, the contact area with a phosphorus-containing copper alloy particle and a tin-containing particle becomes larger, and the reaction with a phosphorus-containing copper alloy particle and a tin-containing particle tends to progress effectively.

In this regard, the D50% of a specific metal M-containing particle is measured similarly as in the case of a phosphorus-containing copper alloy particle.

There is no particular restriction on the shape of a specific metal M-containing particle, and it may be any of nearly spherical, flat, blockish, platy, scaly or the like. From viewpoints of oxidation resistance and reduction of the resistivity of an electrode to be formed, the shape of a specific metal M-containing particle is preferably nearly spherical, flat or platy.

There is no particular restriction on a content of a specific metal M-containing particle in a composition for forming an electrode. Among others, the content of a specific metal M-containing particle is preferably from 4% by mass to 70% by mass with respect to a total content of a phosphorus-containing copper alloy particle, a tin-containing particle and a specific metal M-containing particle as 100% by mass, more preferably from 5% by mass to 65% by mass, further preferably from 5% by mass to 60% by mass, and further more preferably from 6% by mass to 60% by mass.

When the content is 4% by mass or more, a Cu-Sn-M alloy phase can be formed more uniformly. Meanwhile, when the content is 70% by mass or less, a sufficient volume of a Cu-Sn-M alloy phase can be formed, and the volume resistivity of an electrode can further decrease.

There is no particular restriction on a content ratio of a specific metal M-containing particle to a tin-containing particle in a composition for forming an electrode. From a viewpoint of adherence of an electrode to be formed to a silicon substrate, the mass ratio of a specific metal M-containing particle to a tin-containing particle (specific metal M-containing particle / tin-containing particle) is preferably from 0.1 to 4.0, and more preferably from 0.2 to 3.0.

There is no particular restriction on a content ratio of a tin-containing particle and a specific metal M-containing particle to a phosphorus-containing copper alloy particle in a composition for forming an electrode. From viewpoints of reduction of the resistivity of an electrode to be formed under a condition of high temperature thermal treatment (sintering) and the adherence of the electrode to a silicon substrate, the mass ratio of the total of a tin-containing particle and a specific metal M-containing particle to a phosphorus-containing copper alloy particle [(specific metal M-containing particle + tin-containing particle) / phosphorus-containing copper alloy particle] is preferably from 0.3 to 2.5, and more preferably from 0.5 to 1.8.

From viewpoints of oxidation resistance and reduction of the resistivity of an electrode, a total content of a phosphorus-containing copper alloy particle, a tin-containing particle, and a specific metal M-containing particle in a composition for forming an electrode is preferably from 70% by mass to 94% by mass, and more preferably from 74% by mass to 88% by mass.

There is no particular restriction on the ratio of the particle diameter (D50%) of a specific metal M-containing particle to the particle diameter (D50%) of a tin-containing particle. From viewpoints of the homogeneity of a Sn-P-O glass phase to be formed and the adherence of an electrode to be formed to a silicon substrate, the ratio of the particle diameter (D50%) of a specific metal M-containing particle to the particle diameter (D50%) of a tin-containing particle (specific metal M-containing particle / tin-containing particle) is preferably from 0.05 to 20, and more preferably from 0.5 to 10.

There is no particular restriction on the ratio of the particle diameter (D50%) of a tin-containing particle to the particle diameter (D50%) of a phosphorus-containing copper alloy particle. From viewpoints of reduction of the resistivity of an electrode to be formed under a condition of high temperature thermal treatment (sintering) and the adherence of the electrode to a silicon substrate, the ratio of the particle diameter (D50%) of a tin-containing particle to the particle diameter (D50%) of a phosphorus-containing copper alloy particle (tin-containing particle / phosphorus-containing copper alloy particle) is preferably from 0.03 to 30, and more preferably from 0.1 to 10.

There is no particular restriction on the ratio of the particle diameter (D50%) of a specific metal M-containing particle to the particle diameter (D50%) of a phosphorus-containing copper alloy particle. From a viewpoint of reduction of the resistivity of an electrode to be formed under a condition of high temperature thermal treatment (sintering), the ratio of the particle diameter (D50%) of a specific metal M-containing particle to the particle diameter (D50%) of a phosphorus-containing copper alloy particle (specific metal M-containing particle / phosphorus-containing copper alloy particle) is preferably from 0.02 to 20, and more preferably from 0.1 to 10.

### (Glass particle)

A composition for forming an electrode contains at least one kind of glass particle. In a case in which a composition for forming an electrode contains a glass particle, the adherence of a formed electrode to a silicon substrate during a thermal treatment (sintering) is enhanced. Moreover, especially on the occasion of formation of an electrode on the light receiving surface of a photovoltaic cell, a silicon nitride film which is an antireflection film is removed by a so-called fire-through technique during a thermal treatment (sintering) to form an ohmic contact between an electrode and a silicon substrate.

With respect to a glass particle, it is preferable that the softening point is 650°C or less and the crystallization initiation temperature exceeds 650°C from viewpoints of reduction of the resistivity of an electrode to be formed and the adherence of the electrode to a silicon substrate. In this regard, a softening point is measured by an ordinary method using a thermo-mechanical analyzer (TMA), and a crystallization initiation temperature is measured by an ordinary method using a thermogravimetric-differential thermal analyzer (TG-DTA).

In a case in which a composition for forming an electrode is used for forming an electrode on the light receiving surface of a photovoltaic cell, a glass particle used ordinarily in the relevant technical field may be used without particular restriction, insofar as the glass particle softens or melts at a temperature for forming an electrode, contacts an antireflection film composed of silicon nitride to form silicon dioxide by oxidizing the silicon nitride, and captures the silicon dioxide so as to make an antireflection film removable.

Generally, a glass particle contained in a composition for forming an electrode is composed of a glass containing lead, because the same can capture silicon dioxide efficiently. Examples of such a glass containing lead are described in Japanese Patent No. 03050064, which may be used favorably also in the present invention.

However, taking an influence on the environment into consideration, use of a lead-free glass, which does not substantially contain lead, is preferable. Examples of a lead-free glass include a lead-free glass described in Paragraphs 0024 to 0025 of JP-A No. 2006-313744, and a lead-free glass described in JP-A No. 2009-188281 and the like, and it is also preferable that an appropriate lead-free glass is selected from the above, and applied to the present invention.

In a case in which a composition for forming an electrode is used for forming an electrode other than an electrode on the light receiving surface of a photovoltaic cell, for example, a back surface lead-out electrode, and a through-hole electrode or a back electrode of a back contact photovoltaic cell element, a glass particle has preferably a softening point of 650°C or less, and a crystallization initiation temperature of greater than 650°C. Such a glass particle can be used without containing a component such as lead required for fire-through.

Examples of glass components composing a glass particle include silicon oxide (SiO, SiO₂ and the like), phosphorus oxide (P₂O₅), aluminum oxide (Al₂O₃), boron oxide (B₂O₃), vanadium oxide (V₂O₅), potassium oxide (K₂O), bismuth oxide (Bi₂O₃), sodium oxide (Na₂O), lithium oxide (Li₂O), barium oxide (BaO), strontium oxide (SrO), calcium oxide (CaO), magnesium oxide (MgO), beryllium oxide (BeO), zinc oxide (ZnO), lead oxide (PbO), cadmium oxide (CdO), tin oxide (SnO), zirconium oxide (ZrO₂), tungsten oxide (WO₃), molybdenum oxide (MoO₃), lanthanum oxide (La₂O₃), niobium oxide (Nb₂O₅), tantalum oxide (Ta₂O₅), yttrium oxide (Y₂O₃), titanium oxide (TiO₂), germanium oxide (GeO₂), tellurium oxide (TeO₂), lutetium oxide (Lu₂O₃), antimony oxide (Sb₂O₃), copper oxide (CuO and the like), iron oxide (FeO and the like), silver oxide (AgO, Ag₂O and the like), and manganese oxide (MnO).

Among others, use of a glass particle containing at least one selected from the group consisting of SiO₂, P₂O₅, Al₂O₃, B₂O₃, V₂O₅, Bi₂O₃, ZnO and PbO is preferable, and use of a glass particle containing at least one selected from the group consisting of Si0₂, PbO, B₂O₃, Bi₂O₃ and Al₂O₃ is more preferable. In the case of such a glass particle, the softening point decreases more effectively. Further, with such a glass particle, the wettability with respect to a phosphorus-containing copper alloy particle, a tin-containing particle and a specific metal M-containing particle is improved, and therefore sintering among the particles at the thermal treatment (sintering) process advances, so that an electrode with a low resistivity can be formed.

Meanwhile, from a viewpoint of low contact resistivity, a glass particle containing diphosphorus pentoxide (phosphate glass, P₂O₅ glass particle and the like) is preferable, and a glass particle containing further divanadium pentoxide in addition to diphosphorus pentoxide (P₂O₅-V₂O₅ glass particle) is more preferable. When divanadium pentoxide is contained additionaly, the oxidation resistance is improved, and the resistivity of an electrode further decreases. This is presumably because the softening point of the glass decreases, for example, by addition of divanadium pentoxide.

In a case in which a diphosphorus pentoxide-divanadium pentoxide glass particle (P₂O₅-V₂O₅ glass particle) is used, a content of divanadium pentoxide is preferably 1% by mass or more with respect to the total mass of the glass particle, and more preferably from 1% by mass to 70% by mass.

There is no particular restriction on the particle diameter of a glass particle. The D50% of a glass particle is preferably from 0.5 µm to 10 µm, and more preferably from 0.8 µm to 8 µm. When the D50% of a glass particle is 0.5 µm or more, the operability of preparation of a composition for forming an electrode is improved. When the D50% of a glass particle is 10 µm or less, glass particles are dispersed more uniformly in a composition for forming an electrode, so that a fire-through can be formed efficiently at the thermal treatment (sintering) process, and further the adherence of an electrode to be formed to a silicon substrate tends to be improved.

In this regard, the D50% of a glass particle is measured similarly as in the case of a phosphorus-containing copper alloy particle.

There is no particular restriction on the shape of a glass particle, and it may be any of nearly spherical, flat, blockish, platy, scaly or the like. From viewpoints of oxidation resistance and reduction of the resistivity, the shape of a glass particle is preferably nearly spherical, flat or platy.

A content of a glass particle with respect to the total mass of a composition for forming an electrode is preferably from 0.1% by mass to 10% by mass, more preferably from 0.5% by mass to 8% by mass, and further preferably from 1% by mass to 8% by mass. When the content of a glass particle is within the range, the oxidation resistance, reduction of the resistivity of an electrode, and reduction of the contact resistivity can be achieved more effectively, and the reaction among a phosphorus-containing copper alloy particle, a tin-containing particle and a specific metal M-containing interparticle can be promoted.

The mass ratio of a glass particle in a composition for forming an electrode with respect to the total mass of a phosphorus-containing copper alloy particle, a tin-containing particle and a specific metal M-containing particle [glass particle / (phosphorus-containing copper alloy particle + tin-containing particle + specific metal M-containing particle)] is preferably from 0.01 to 0.15, and more preferably from 0.03 to 0.12. When the content of a glass particle is within the range, the oxidation resistance, reduction of the resistivity of an electrode, and reduction of the contact resistivity can be achieved more effectively, and the reaction among a phosphorus-containing copper alloy particle, a tin-containing particle and a specific metal M-containing interparticle can be promoted.

The ratio of the particle diameter (D50%) of a glass particle to the particle diameter (D50%) of a phosphorus-containing copper alloy particle (glass particle / phosphorus-containing copper alloy particle) is preferably from 0.05 to 100, and more preferably from 0.1 to 20. When the ratio of the particle diameter is within the range, the oxidation resistance, reduction of the resistivity of an electrode, and reduction of the contact resistivity can be achieved more effectively, and the reaction among a phosphorus-containing copper alloy particle, a tin-containing particle and a specific metal M-containing interparticle can be promoted.

### (Solvent and resin)

A composition for forming an electrode contains at least one kind of solvent, and at least one kind of resin. By this means, the liquid physical properties (viscosity, surface tension or the like) of a composition for forming an electrode can be regulated into a range suitable for an application method for application to a silicon substrate or the like.

There is no particular restriction on a solvent. Examples of a solvent include a hydrocarbon solvent such as hexane, cyclohexane and toluene; a halogenated hydrocarbon solvent such as dichloroethylene, dichloroethane and dichlorobenzene; a cyclic ether solvent such as tetrahydrofuran, furan, tetrahydropyran, pyran, dioxane, 1,3-dioxolane and trioxane; an amide solvent such as *N,N*-dimethylformamide and *N,N*-dimethylacetamide; a sulfoxide solvent such as dimethylsulfoxide and diethylsulfoxide; a ketone solvent such as acetone, methyl ethyl ketone, diethyl ketone and cyclohexanone; an alcohol solvent such as ethanol, 2-propanol, 1-butanol and diacetone alcohol; a polyhydric alcohol ester solvent such as 2,2,4-trimethyl-1,3-pentanediol monoacetate, 2,2,4-trimethyl-1,3-pentanediol monopropiolate, 2,2,4-trimethyl-1,3-pentanediol monobutyrate, 2,2,4-trimethyl-1,3-pentanediol monoisobutyrate, 2,2,4-triethyl-1,3-pentanediol monoacetate, ethylene glycol monobutyl ether acetate and diethylene glycol monobutyl ether acetate; a polyhydric alcohol ether solvent such as butyl cellosolve, diethylene glycol monobutyl ether and diethylene glycol diethyl ether; a terpene solvent such as α-terpinene, α-terpineol, myrcene, allo-ocimene, limonene, dipentene, α-pinene, β-pinene, terpineol, carvone, ocimene and phellandrene. The solvents may be used singly or in a combination of two or more kinds.

As a solvent, from a viewpoint of an application property (coating property and printing property) of a composition for forming an electrode on to a silicon substrate, at least one selected from the group consisting of a polyhydric alcohol ester solvent, a terpene solvent and a polyhydric alcohol ether solvent is preferable, and at least one selected from the group consisting of a polyhydric alcohol ester solvent and a terpene solvent is more preferable.

There is no particular restriction on a resin, and a resin used ordinarily in the relevant technical field may be used, insofar as the resin can be thermally degraded by a thermal treatment (sintering). A resin may be a natural polymer or a synthesis polymer. Specific examples of a resin include a cellulosic resin such as methyl cellulose, ethyl cellulose, carboxymethyl cellulose and nitrocellulose; a poly(vinyl alcohol) compound; a poly(vinylpyrrolidone) compound; an acrylic resin; a vinyl acetate-acrylic ester copolymer; a butyral resin such as poly(vinyl butyral); an alkyd resin such as a phenol-modified alkyd resin and a castor oil fatty acid-modified alkyd resin; an epoxy resin; a phenolic resin; and a rosin ester resin. The resins may be used singly or in a combination of two or more kinds.

As a resin from viewpoints of volatility by a thermal treatment (sintering), at least one selected from the group consisting of a cellulosic resin and an acrylic resin is preferable.

There is no particular restriction on the weight-average molecular weight of a resin. Among others, the weight-average molecular weight of a resin is preferably 5,000 or more and 500,000 or less, and more preferably from 10,000 to 300,000. When the weight-average molecular weight of a resin is 5,000 or more, increase in the viscosity of a composition for forming an electrode tends to be suppressed. This is presumably, for example, because steric repulsion caused by adsorption of a resin on a phosphorus-containing copper alloy particle, a tin-containing particle, and a specific metal M-containing particle becomes large enough, so that aggregation of the particles is suppressed. Meanwhile, when the weight-average molecular weight of a resin is 500,000 or less, aggregation of the particles in a solvent is suppressed, and increase in the viscosity of a composition for forming an electrode tends to be suppressed. Further, when the weight-average molecular weight of a resin is 500,000 or less, rise in the burning temperature of a resin is suppressed, and it is suppressed that a resin is not burnt completely on an occasion of a thermal treatment (sintering) of a composition for forming an electrode, thereby preventing a resin from remaining as a foreign substance, so that an electrode with a lower resistance tends to be formed.

A weight-average molecular weight is determined by calculation using a calibration curve based on standard polystyrenes from a molecular weight distribution measured using a GPC (gel permeation chromatography). The calibration curve is prepared using a set of 5 samples of standard polystyrenes (trade name: PSt QUICK MP-H, PSt QUICK B, produced by Tosoh Corporation) and after approximation with a cubic equation. The measurement conditions for GPC are as follows.

Apparatus: (pump: L-2130 Model, produced by Hitachi High-Technologies Corp.), (detector: RI, L-2490 Model, produced by Hitachi High-Technologies Corp.), (column oven: L-2350, produced by Hitachi High-Technologies Corp.)

Column: GELPACK GL-R440 + GELPACK GL-R450 + GELPACK GL-R400M (total 3 columns) ((trade name) produced by Hitachi Chemical Co., Ltd.)
Column size: 10.7 mm×300 mm (inner diameter)
Eluent: tetrahydrofuran
Sample concentration: 10 mg / 2 mL
Injection amount: 200 µL
Flow rate: 2.05 mL/min
Measurement temperature: 25°C

A contents of a solvent and a resin in a composition for forming an electrode may be selected appropriately depending on a desired liquid physical properties and the kinds of solvent and resin used. For example, a total content of a solvent and a resin with respect to the total mass of a composition for forming an electrode is preferably from 3% by mass to 29.9% by mass, more preferably from 5% by mass to 25% by mass, and further preferably from 7% by mass to 20% by mass.

When the total content of a solvent and a resin is within the range, the application suitability for applying a composition for forming an electrode to a silicon substrate can be favorable and an electrode with a desired width and height can be formed more easily.

In a composition for forming an electrode from viewpoints of oxidation resistance and reduction of the resistivity of an electrode, it is preferable that the total content of a phosphorus-containing copper alloy particle, a tin-containing particle and a specific metal M-containing particle is from 70% by mass to 94% by mass, the content of a glass particle is from 0.1% by mass to 10% by mass, and the total content of a solvent and a resin is from 3% by mass to 29.9% by mass, more preferable that the total content of a phosphorus-containing copper alloy particle, a tin-containing particle and a specific metal M-containing particle is from 74% by mass to 88% by mass, the content of a glass particle is from 0.5% by mass to 8% by mass, and the total content of a solvent and a resin is from 5% by mass to 25% by mass, and further preferable that the total content of a phosphorus-containing copper alloy particle, a tin-containing particle and a specific metal M-containing particle is from 74% by mass to 88% by mass, the content of a glass particle is from 1% by mass to 8% by mass, and the total content of a solvent and a resin is from 7% by mass to 20% by mass.

### (Flux)

A composition for forming an electrode may contain further at least one kind of flux. By containing a flux, when an oxidized film is formed on a surface of a phosphorus-containing copper alloy particle, the oxidized film can be removed, and a reduction reaction of a phosphorus-containing copper alloy particle during a thermal treatment (sintering) can be promoted. Further, melting of a tin-containing particle during a thermal treatment (sintering) is promoted so that a reaction between a tin-containing particle and a phosphorus-containing copper alloy particle is advanced, and as the result the oxidation resistance is improved and the resistivity of an electrode to be formed decreases. Further, by containing a flux, an effect that the adherence of an electrode to a silicon substrate is enhanced can be also obtained.

There is no particular restriction on a flux, insofar as it can remove an oxidized film to be formed on a surface of a phosphorus-containing copper alloy particle, and promote melting of a tin-containing particle. Specific examples of a preferable flux include a fatty acid, a boric acid compound, a fluoride compound, and a borofluoride compound. The fluxes may be used singly or in a combination of two or more kinds.

More specific examples of a flux include lauric acid, myristic acid, palmitic acid, stearic acid, sorbic acid, stearolic acid, propionic acid, boron oxide, potassium borate, sodium borate, lithium borate, potassium borofluoride, sodium borofluoride, lithium borofluoride, acidic potassium fluoride, acidic sodium fluoride, acidic lithium fluoride, potassium fluoride, sodium fluoride and lithium fluoride.

Among others, examples of a more preferable flux, from viewpoints of heat resistance during a thermal treatment (sintering) (property that a flux does not volatilize during a low temperature phase of the thermal treatment (sintering)) and supplementation of the oxidation resistance of a phosphorus-containing copper alloy particle, include potassium borate, and potassium borofluoride.

In a case in which a composition for forming an electrode contains a flux, from viewpoints of effective manifestation of the oxidation resistance of a phosphorus-containing copper alloy particle, and promotion of melting of a tin-containing particle, and a viewpoint of reduction of voidage to be formed by removal of a flux at the end of a thermal treatment (sintering), a content of a flux with respect to the total mass of a composition for forming an electrode is preferably from 0.1% by mass to 5% by mass, more preferably from 0.3% by mass to 4% by mass, further preferably from 0.5% by mass to 3.5% by mass, further more preferably from 0.7 to 3% by mass, and extremely preferably from 1% by mass to 2.5% by mass.

### (Other components)

A composition for forming an electrode may contain, if necessary, other components used ordinarily in the relevant technical field in addition to the afore-described components. Examples of other components include a plasticizer, a dispersant, a surfactant, an inorganic binder, a metallic oxide, a ceramic and an organometallic compound.

### <Method of producing composition for forming electrode>

There is no particular restriction on a method of producing a composition for forming an electrode. The composition can be produced by dispersing and mixing a phosphorus-containing copper alloy particle, a tin-containing particle, a specific metal M-containing particle, a glass particle, a solvent, a resin and the like by a dispersing method and a mixing method used ordinarily.

There is no particular restriction on a dispersing method and a mixing method, and an appropriate method to be selected from dispersing methods and mixing methods used ordinarily may be applied.

### <Method of producing electrode using composition for forming electrode>

In a method for producing an electrode using a composition for forming an electrode, a composition for forming an electrode is applied to a region where an electrode is to be formed, dried according to need, and then subjected to a thermal treatment (sintering), so that an electrode can be formed in a desired region. By using the composition for forming an electrode, an electrode with a low resistivity can be formed, even when a thermal treatment (sintering) is carried out in the presence of oxygen (for example, in the air).

Specifically, for example, when a photovoltaic cell electrode is formed using the composition for forming an electrode, the composition for forming an electrode is applied on a silicon substrate in a desired shape, dried according to need, and then subjected to a thermal treatment (sintering), so that a photovoltaic cell electrode with a low resistivity can be formed in the desired shape. In this case, since the composition for forming an electrode is used, an electrode with a low resistivity can be formed, even when a thermal treatment (sintering) is carried out in the presence of oxygen (for example, in the air). Further, an electrode formed on a silicon substrate using the composition for forming an electrode is superior in the adherence to the silicon substrate, and a favorable ohmic contact can be established.

Examples of a method for applying a composition for forming an electrode include a screen printing method, an ink jet method, and a dispenser method, and a screen printing method is preferable from a viewpoint of productivity.

When a composition for forming an electrode is applied by a screen printing method, a composition for forming an electrode is preferably in a paste form. A composition for forming an electrode has preferably a viscosity in a range of from 20 Pa·s to 1,000 Pa·s. In this regard, the viscosity of a composition for forming an electrode is measured with a Brookfield HBT viscometer at 25°C.

The application amount of a composition for forming an electrode may be selected appropriately depending on the dimension of an electrode. The application amount of a composition for forming an electrode may be, for example, from 2 g/m² to 10 g/m², and preferably from 4 g/m² to 8 g/m².

As thermal treatment (sintering) conditions in forming an electrode using a composition for forming an electrode, thermal treatment conditions used ordinarily in the relevant technical field may be applied.

With respect to a thermal treatment (sintering) temperature, although a range of from 800°C to 900°C is generally used, in the event a composition for forming an electrode in the present invention is used, a broader range of from a thermal treatment condition at a lower temperature to a general thermal treatment condition may be used. For example, in a broad thermal treatment temperature range of from 450°C to 900°C, an electrode having favorable characteristics can be formed.

Further, a thermal treatment time may be selected appropriately depending on the thermal treatment temperature or the like, and the time may be, for example, from 1 sec to 20 sec.

A thermal treatment apparatus may be adopted appropriately, insofar as heating to the afore-described temperature is possible, and examples thereof include an infrared heating oven and a tunnel oven. Since in an infrared heating oven, electrical energy is inputted to a heating material in a form of electromagnetic waves and converted to thermal energy, it is highly efficient, and rapid heating within a shorter time is possible. Further, using an infrared heating oven, due to absence of a combustion product and also due to non-contact heating, an electrode to be formed can be prevented from contamination. Since in a tunnel oven a sample is thermal-treated (sintered) while conveying automatically from an entrance to an exit, a thermal treatment (sintering) can be performed more uniformly by segmentation of the oven body and regulation of the conveyor speed. A thermal treatment with a tunnel oven is appropriate from a viewpoint of the electricity generation performance of a photovoltaic cell element.

### <Photovoltaic cell element and method of producing thereof>

A photovoltaic cell element in the present invention contains at least a silicon substrate, and an electrode, which is a thermal-treated (sintered) product of the composition for forming an electrode provided on the silicon substrate. By this means, a photovoltaic cell element having favorable characteristics can be yielded, and the photovoltaic cell element is superior in productivity.

In this regard, a photovoltaic cell element means herein one having a silicon substrate with a pn junction formed and an electrode formed on the silicon substrate.

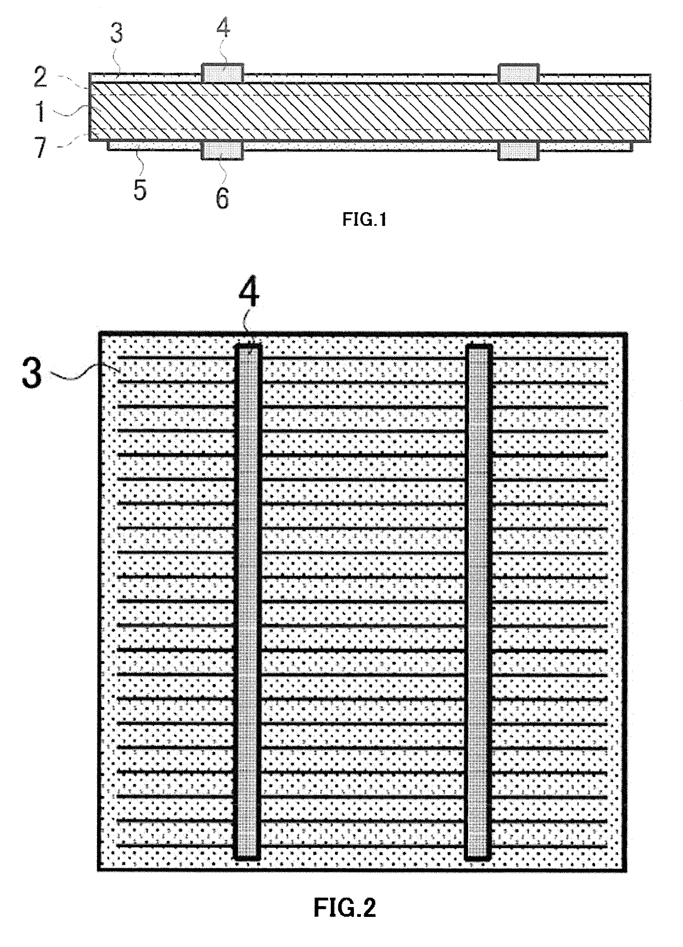

Embodiments of a photovoltaic cell element in the present invention will be described below referring to drawings, provided that the present invention be not limited thereto. As an example of a typical photovoltaic cell element, a schematic cross-sectional view, a schematic plan view of a light receiving surface, and a schematic plan view of a back surface are shown in Fig. 1, Fig. 2, and Fig. 3 respectively.

As shown in a schematic cross-sectional view in Fig. 1, an n⁺-type diffusion layer 2 is formed near a surface of one side of a semiconductor substrate 1, and an output power lead-out electrode 4 and an antireflection film 3 are formed on the n⁺-type diffusion layer 2. Further, a p⁺-type diffusion layer 7 is formed near the other surface, and a back surface output power lead-out electrode 6 and a back surface collector electrode 5 are formed on the p⁺-type diffusion layer 7. As a semiconductor substrate 1 for a photovoltaic cell element, a monocrystalline or polycrystalline silicon substrate is used ordinarily. The semiconductor substrate 1 contains boron or the like to constitute a p-type semiconductor. On the light receiving surface, concavo-convex shape (also called as texture, not illustrated) is formed using an etching solution containing NaOH and IPA (isopropyl alcohol) so as to suppress reflection of solar light. On the light receiving surface side, phosphorus or the like is doped to form an n⁺-type diffusion layer 2 with a thickness of submicron order, and a pn junction is formed in a boundary with a p-type bulk portion. Further on the light receiving surface side, an antireflection film 3 made of silicon nitride or the like is formed by PECVD or the like in a thickness of about 90 nm on the n⁺-type diffusion layer 2.

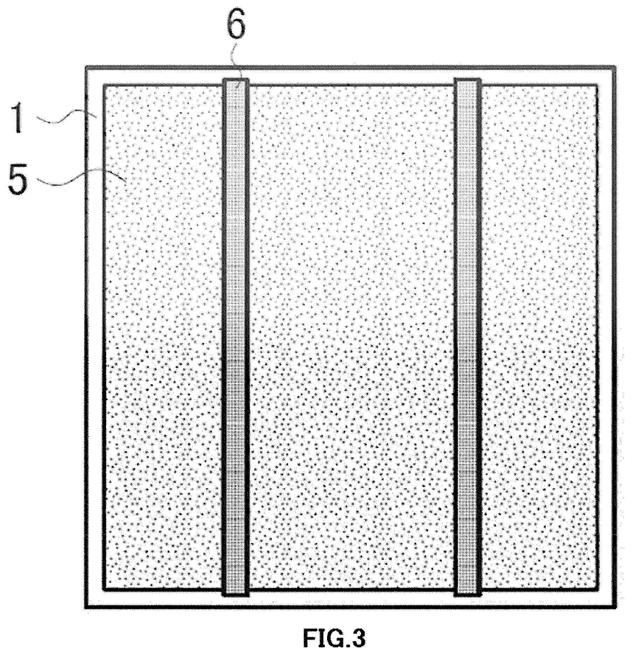

Next, methods of forming a light receiving surface electrode 4 provided on the light receiving surface side schematically illustrated in Fig. 2, as well as a back surface collector electrode 5 and a back surface output power lead-out electrode 6 to be formed on the back surface schematically illustrated in Fig. 3 will be described.

The light receiving surface electrode 4 and the back surface output power lead-out electrode 6 are formed of the foregoing composition for forming an electrode. The back surface collector electrode 5 is formed of a composition for forming an aluminum electrode containing a glass particle. As an example of the first method for forming a light receiving surface electrode 4, a back surface collector electrode 5, and a back surface output power lead-out electrode 6, there is a method by which the composition for forming an electrode and the composition for forming an aluminum electrode are applied by screen printing or the like in desired patterns, and then collectively subjected to a thermal treatment (sintering) in the air at approximately from 450°C to 900°C. By using the composition for forming an electrode, a light receiving surface electrode 4 and a back surface output power lead-out electrode 6 superior in resistivity and contact resistivity can be formed, even when a thermal treatment (sintering) is performed at a relatively low temperature.

On the light receiving surface side, during a thermal treatment (sintering), a glass particle contained in the composition for forming the light receiving surface electrode 4 reacts with the antireflection film 3 (fire through) so that the light receiving surface electrode 4 connects electrically (form an ohmic contact) to the n⁺-type diffusion layer 2.

In accordance with the present invention, since a light receiving surface electrode 4 is formed using the foregoing composition for forming an electrode, despite the presence of copper as an electrically conductive metal, oxidation of the copper is suppressed and a light receiving surface electrode 4 with a low resistivity can be formed at a favorable productivity.

Further, in accordance with the present invention, an electrode to be formed should preferably be constituted including a Cu-Sn-M alloy phase, and if necessary a Cu-Sn alloy phase and a Sn-P-O glass phase, and more preferably including a Sn-P-O glass phase placed between a Cu-Sn alloy phase or a Cu-Sn-M alloy phase and a silicon substrate (not illustrated). By this means a reaction between copper and silicon in a silicon substrate can be suppressed, and an electrode with low resistance and superior in adherence can be formed.

On the back surface side, aluminum in a composition for forming an aluminum electrode, which forms a back surface collector electrode 5, diffuses to the back surface of a semiconductor substrate 1 during a thermal treatment (sintering) to form a p⁺-type diffusion layer 7, so that an ohmic contact can be established between the semiconductor substrate 1 and the back surface collector electrode 5, or a back surface output power lead-out electrode 6.

As an example of the second method for forming a light receiving surface electrode 4, a back surface collector electrode 5, and a back surface output power lead-out electrode 6, there is a method by which a composition for forming an aluminum electrode for forming the back surface collector electrode 5 is first applied, dried, and then subjected to a thermal treatment (sintering) in the air at approximately from 750°C to 900°C to complete the back surface collector electrode 5, and thereafter a composition for forming an electrode in the present invention is applied to the light receiving surface side and the back surface side, dried, and then subjected to a thermal treatment (sintering) in the air at approximately from 450°C to 650°C to complete the light receiving surface electrode 4 and the back surface output power lead-out electrode 6.

The method is effective, for example, for the following case. Namely, when a composition for forming an aluminum electrode for forming a back surface collector electrode 5 is thermal-treated (sintered) at a temperature of thermal treatment (sintering) of 650°C or less, depending on a constituent of the composition for forming an aluminum electrode, a p⁺-type diffusion layer may occasionally not be formed adequately due to insufficiency of sintering of aluminum particles and the diffusion amount of aluminum to the semiconductor substrate 1. In such a state, an ohmic contact on the back surface between a semiconductor substrate 1 and a back surface collector electrode 5, or a back surface output power lead-out electrode 6 may not be established adequately, so that the electricity generation performance of a photovoltaic cell element may be compromised. Therefor it is preferable that the back surface collector electrode 5 is formed at optimal temperature of a thermal treatment (sintering) for a composition for forming an aluminum electrode (for example, from 750°C to 900°C), and then a composition for forming an electrode in the present invention is applied, dried, and thermal-treated (sintered) at a relatively low temperature (from 450°C to 650°C) to form the light receiving surface electrode 4 and the back surface output power lead-out electrode 6.

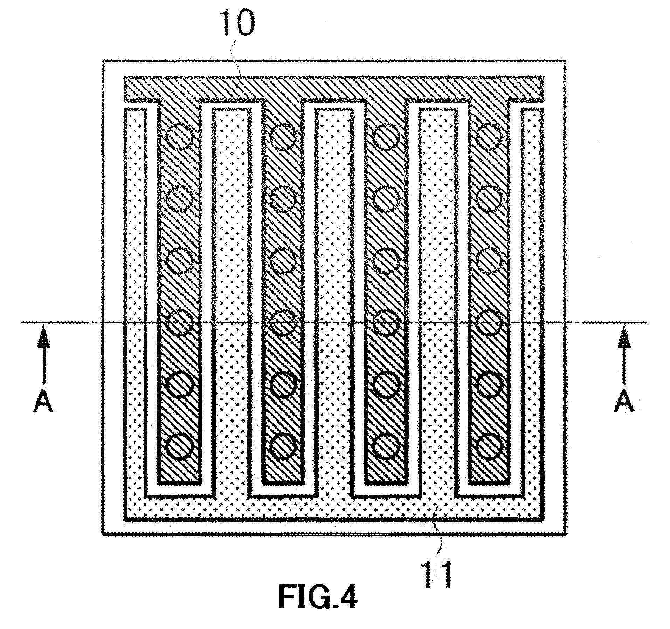

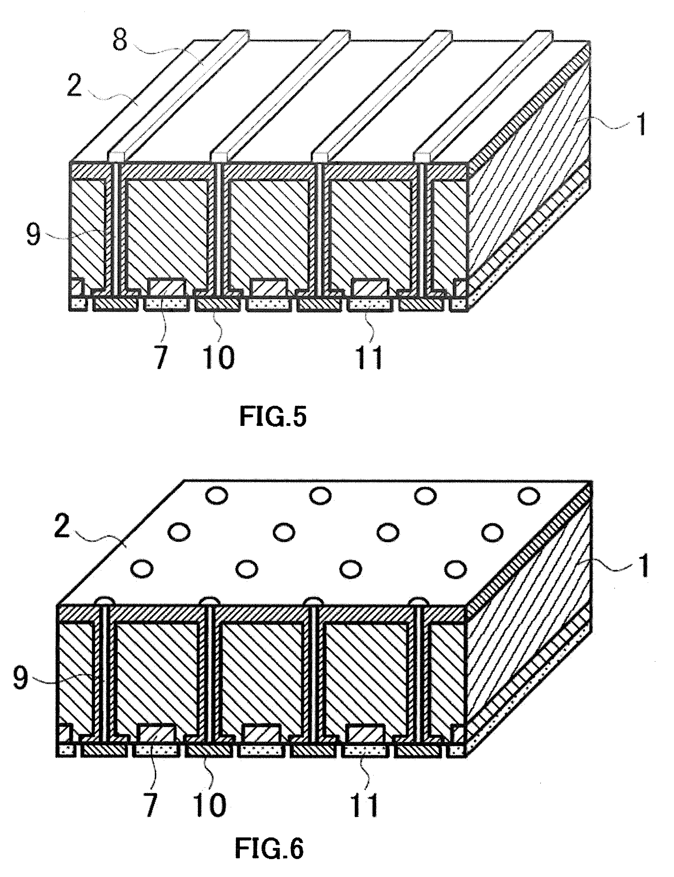

A schematic plan view of a back surface side electrode structure, which is common among so-called back contact photovoltaic cell elements, is shown in Fig. 4 as other embodiment in the present invention, and perspective views of a schematic structure of a photovoltaic cell element, which are other embodiments of a back contact photovoltaic cell element, are shown in Fig. 5, Fig. 6 and Fig. 7. In this regard, Fig. 5, Fig. 6 and Fig. 7 are respectively perspective views for an A-A cross-section in Fig. 4.

In a semiconductor substrate 1 of a photovoltaic cell element having the structure shown in a perspective view of Fig. 5, through-holes penetrating both surfaces from the light receiving surface side to the back surface side are formed by a laser drill, etching or the like. Further, a texture (not illustrated) for improving the light incoming efficiency is formed on the light receiving surface side. Further, on the light receiving surface side, an n⁺-type diffusion layer 2 by a diffusion treatment for conversion to an n-type, and an antireflection film (not illustrated) are formed on the n⁺-type diffusion layer 2. These are produced by a process similar to that for a conventional Si photovoltaic cell element.

Next, a composition for forming an electrode in the present invention is filled into the through-holes formed previously by a printing method or an ink jet method, and further a composition for forming an electrode in the present invention is also applied in a grid shape on the light receiving surface side to form composition layers for forming through-hole electrodes 9 and light receiving surface collector electrodes 8.

It is preferable that the compositions for filling and application are optimally selected respectively in terms of viscosity or the like depending on methods. Alternatively, the compositions for filling and application may have the same constituents, and processes of filling and application may be carried out together.

Meanwhile, on the back surface side, an n⁺-type diffusion layer 2 and a p⁺-type diffusion layer 7 for preventing carrier recombination are formed. In this regard, as an impurity element for forming a p⁺-type diffusion layer 7, boron (B), aluminum (Al) or the like are used. The p⁺-type diffusion layer 7 may be formed, for example, by performing a thermal diffusion treatment using B as a diffusion source at a process before formation of an antireflection film. Alternatively, in a case in which Al is used as an impurity element, the p⁺-type diffusion layer 7 may be formed by using a composition for forming an aluminum electrode applied on the opposite surface side, then followed by a thermal treatment (sintering).

On the back surface side as shown in a plan view of Fig. 4, back electrodes 10 and 11 are formed by applying respectively a composition for forming an electrode in the present invention on to the n⁺-type diffusion layer 2 and the p⁺-type diffusion layer 7 in stripe forms. In this regard, in a case in which a p⁺-type diffusion layer 7 is formed using a composition for forming an aluminum electrode, a composition for forming an electrode in the present invention is applied only on the n⁺-type diffusion layer 2 to form back electrodes.

Then after drying, a thermal treatment (sintering) is performed in the air at approximately from 450°C to 900°C to form a light receiving surface collector electrode 8, through-hole electrodes 9, and back electrodes 10 and 11. Further, as described above, in a case in which either of the back electrodes is an aluminum electrode, from viewpoints of a sintering property of aluminum and ohmic contact characteristics between back electrodes and a p⁺-type diffusion layer 7, first a composition for forming an aluminum electrode may be applied, and thermal-treated (sintered) to form either of the back electrodes, and thereafter a composition for forming an electrode in the present invention may be applied, filled and thermal-treated (sintered) to form the light receiving surface collector electrode 8, the through-hole electrodes 9, and the other back electrode.

A photovoltaic cell element having a structure shown in a perspective view of Fig. 6 can be produced identically with a photovoltaic cell element having a structure shown in a perspective view of Fig. 5 except that light receiving surface collector electrodes are not formed. In other words, for a photovoltaic cell element having a structure shown in a perspective view of Fig. 6, a composition for forming an electrode in the present invention can be used for forming through-hole electrodes 9, and back electrodes 10 and 11.

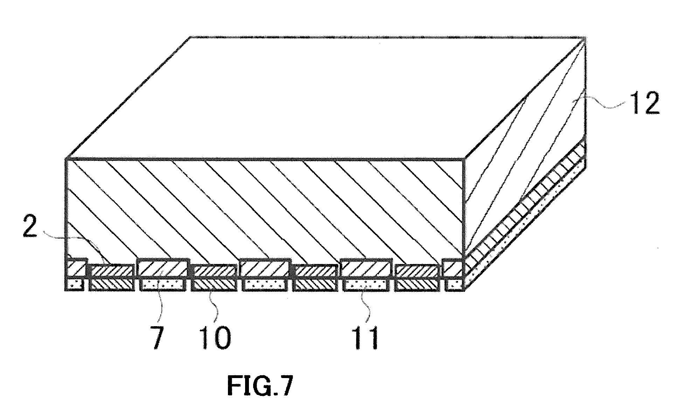

A photovoltaic cell element having a structure shown in a perspective view of Fig. 7 can be produced identically with a photovoltaic cell element having a structure shown in a perspective view of Fig. 5 except that a n-type silicon substrate is used as a semiconductor substrate 1 serving as a base, and a through-hole is not formed. In other words, for a photovoltaic cell element having a structure shown in a perspective view of Fig. 7, a composition for forming an electrode in the present invention can be used for forming back electrodes 10 and 11.

A composition for forming an electrode in the present invention is not limited to the use in a photovoltaic cell electrode, and can be favorably applied to uses, such as an electrode wiring for a plasma display, a shield wiring, a ceramic capacitor, an antenna circuit, various sensor circuits, and a heat dissipation material for a semiconductor device.

Among them, the composition can be used especially favorably for forming an electrode on a silicon-containing substrate.

### <Photovoltaic cell>

A photovoltaic cell means herein a photovoltaic cell element in a state where a wiring material such as a tab line is provided on an electrode of a photovoltaic cell element and, if necessary, a plurality of photovoltaic cell elements are connected through the wiring material, and the assembly is sealed with an sealing resin.

A photovoltaic cell in the present invention includes at least one piece of the photovoltaic cell element and is constituted together with a wiring material placed on an electrode of the photovoltaic cell element. A photovoltaic cell may be also, if necessary, constituted such that a plurality of photovoltaic cell elements are connected through a wiring material, and the assembly is sealed with an sealing material.

There is no particular restriction on a wiring material and a sealing material, and the same may be appropriately selected from those used ordinarily in the field.

### EXAMPLES

The present invention will be described more specifically below by way of examples, provided that the present invention be not limited to the examples. The expressions of "part" and "%" herein are based on mass, unless otherwise specified.

### <Example 1 >

### (a) Preparation of composition 1 for forming electrode

A phosphorus-containing copper alloy containing 7% by mass of phosphorus was prepared by an ordinarily method, which was then dissolved, pulverized by a water atomization method, then dried and classified. The classified powder was blended with an inert gas for a deoxygenation and dehydration treatment to produce a phosphorus-containing copper alloy particle containing 7% by mass of phosphorus. The particle diameter (D50%) of the phosphorus-containing copper alloy particle was 5.0 µm and the shape thereof was nearly spherical.

A glass composed of 3 parts of silicon dioxide (SiO₂), 60 parts of lead oxide (PbO), 18 parts of boron oxide (B₂O₃), 5 parts of bismuth oxide (Bi₂O₃), 5 parts of aluminum oxide (Al₂O₃), and 9 parts of zinc oxide (ZnO) was prepared (hereinafter occasionally abbreviated as "G01"). The softening point of the obtained glass G01 was 420°C, and the crystallization temperature was greater than 650°C.

Using the obtained glass G01 a glass G01 particle with a particle diameter (D50%) of 2.5 µm was obtained. The shape thereof was nearly spherical.

The glass particle shape was determined by observation with a scanning electron microscope TM-1000 Model produced by Hitachi High-Technologies Corp. The average particle diameter of a glass particle was computed using a laser scattering diffraction particle size distribution analyzer LS 13 320 Model produced by Beckman Coulter, Inc. (measurement wavelength: 632 nm). The softening point of a glass was determined using a simultaneous thermogravimetry/differential thermal analyzer DTG-60H Model produced by Shimadzu Corporation from a differential thermal analysis (DTA) curve.

A composition 1 for forming an electrode was prepared by mixing 33.3 parts of the obtained phosphorus-containing copper alloy particle, 22.8 parts of a tin particle (Sn: particle diameter (D50%): 5.0 µm; purity: 99.9%), 22.2 parts of a nickel particle (Ni: particle diameter (D50%) : 5.0 µm; purity: 99.9%), 7.8 parts of the glass G01 particle, 11.7 parts of diethylene glycol monobutyl ether (BC), and 2.2 parts of poly(ethyl acrylate) (EPA, weight-average molecular weight: 155,000, produced by Fujikura Kasei Co., Ltd.), and then milling the mixture in an automated mortar kneader into a paste form.

### (b) Production of photovoltaic cell element

A p-type semiconductor substrate with a thickness of 190 µm, on which light receiving surface an n⁺-type diffusion layer, a texture, and an antireflection film (silicon nitride film) were formed, was prepared, and cut to a size of 125 mm×125 mm. On the light receiving surface thereof, the composition 1 for forming an electrode obtained above was printed by a screen printing method in the electrode pattern as shown in Fig. 2. The electrode pattern was constructed with 150 µm-wide finger lines and 1.5 mm-wide busbars, and the printing conditions (screen plate mesh size, printing speed and printing pressure) were adjusted appropriately, such that the thickness after a thermal treatment (sintering) became 20 µm. The printed product was placed in an oven heated to 150°C for 15 min to remove the solvent by evaporation.

Next, a composition 1 for forming an electrode and a composition for forming an aluminum electrode were printed similarly as above by screen printing on a surface opposite to the light receiving surface (hereinafter also referred to as "back surface") in the electrode pattern as shown in Fig. 3.

The pattern of a back surface output power lead-out electrode 6 composed of a composition 1 for forming an electrode was configured in a size of 123 mm×5 mm and printed at 2 regions. The printing conditions (screen plate mesh size, printing speed and printing pressure) were adjusted appropriately, such that the thickness of the back surface output power lead-out electrode 6 after a thermal treatment (sintering) became 20 µm. A composition for forming an aluminum electrode was printed over the entire surface excluding the back surface output power lead-out electrode 6 to form a pattern of a back surface collector electrode 5. Further, the printing conditions of the composition for forming an aluminum electrode were adjusted appropriately, such that the thickness of the back surface collector electrode 5 after a thermal treatment (sintering) became 30 µm. The printed product was placed in an oven heated to 150°C for 15 min to remove the solvent by evaporation.

Next, a thermal treatment (sintering) was conducted in a tunnel oven (W/B tunnel oven, single lane conveyor, produced by Noritake Co., Limited) in the air atmosphere, at the maximum temperature of 800°C, and for a retention time of 10 sec to produce a photovoltaic cell element 1 with intended electrodes thus formed.

### <Example 2>

A photovoltaic cell element 2 was produced identically with Example 1, except that the thermal treatment (sintering) conditions in forming an electrode in Example 1 were changed from at the maximum temperature of 800°C for 10 sec, to at the maximum temperature of 850°C for 8 sec.

### <Example 3>

A photovoltaic cell element 3 was produced by preparing a composition 3 for forming an electrode identically with Example 1, except that a manganese particle (Mn) with a particle diameter of 3 µm was used as a specific metal M-containing particle instead of a nickel particle (Ni) in Example 1.

### <Example 4>

A photovoltaic cell element 4 was produced by preparing a composition 4 for forming an electrode identically with Example 1, except that a silver particle (Ag) with a particle diameter of 1.5 µm was used as a specific metal M-containing particle instead of a nickel particle (Ni) in Example 1, and a contents of the respective components of the composition for forming an electrode were changed as set forth in Table 1.

### <Example 5>

A photovoltaic cell element 5 was produced by preparing a composition 5 for forming an electrode identically with Example 1, except that a calcium particle (Ca) with a particle diameter of 10 µm was used as a specific metal M-containing particle instead of a nickel particle (Ni) in Example 1, and a contents of the respective components of the composition for forming an electrode were changed as set forth in Table 1.

### <Example 6>

A photovoltaic cell element 6 was produced by preparing a composition 6 for forming an electrode identically with Example 1, a magnesium particle (Mg) with a particle diameter of 3.0 µm was used except that as a specific metal M-containing particle instead of a nickel particle (Ni) in Example 1, and a contents of the respective components of the composition for forming an electrode were changed as set forth in Table 1.

### <Example 7>

A photovoltaic cell element 7 was produced by preparing a composition 7 for forming an electrode identically with Example 1, except that a bismuth particle (Bi) with a particle diameter of 5.0 µm was used as a specific metal M-containing particle instead of a nickel particle (Ni) in Example 1. and a contents of the respective components of the composition for forming an electrode were changed as set forth in Table 1.

### <Example 8>

A photovoltaic cell element 8 was produced by preparing a composition 8 for forming an electrode identically with Example 1, except that a copper particle (Cu) with a particle diameter of 5.0 µm was used as a specific metal M-containing particle instead of a nickel particle (Ni) in Example 1, and a contents of the respective components of the composition for forming an electrode were changed as set forth in Table 1.

### <Example 9>

A photovoltaic cell element 9 was produced by preparing a composition 9 for forming an electrode identically with Example 1, except that a tin alloy particle composed of Sn-4Ag-0.5Cu (alloy of Sn containing 4% by mass of Ag and 0.5% by mass of Cu) with a particle diameter (D50%) of 8.0 µm was used as a tin-containing particle instead of a tin particle (Sn) in Example 1.

### <Example 10>

A photovoltaic cell element 10 was produced by preparing a composition 10 for forming an electrode identically with Example 1, except that a nickel alloy particle composed of Ni-60Cu (Ni alloy containing 60% by mass of Cu) with a particle diameter (D50%) of 7.0 µm was used as a specific metal M-containing particle instead of a nickel particle (Ni) in Example 1.

### <Example 11>

A photovoltaic cell element 11 was produced by preparing a composition 11 for forming an electrode identically with Example 1, except that a silver particle (Ag) with a particle diameter 1.5 µm was used as a specific metal M-containing particle in addition to a nickel particle (Ni, particle diameter of 10 µm) in Example 1, and a contents of the respective components of the composition for forming an electrode were changed as set forth in Table 1.

### <Example 12>

A photovoltaic cell element 12 was produced by preparing a composition 12 for forming an electrode identically with Example 1, except that a tantalum particle (Ta) with a particle diameter 5.0 µm was used as a specific metal M-containing particle in addition to a nickel particle (Ni, particle diameter of 10 µm) in Example 1, and a contents of the respective components of the composition for forming an electrode were changed as set forth in Table 1.

### <Example 13>

A photovoltaic cell element 13 was produced by preparing a composition 13 for forming an electrode identically with Example 1, except that the composition of the glass particle was changed from the glass G01 in Example 1 to the glass G02 described below.

The glass G02 was prepared such that the same was composed of 45 parts of vanadium oxide (V₂O₅), 24.2 parts of phosphorus oxide (P₂O₅), 20.8 parts of barium oxide (BaO), 5 parts of antimony oxide (Sb₂O₃), and 5 parts of tungsten oxide (WO₃). The softening point of the glass G02 was 492°C, and the crystallization initiation temperature thereof was greater than 650°C.

Using the obtained glass G02, a glass G02 particle with a particle diameter (D50%) of 2.5 µm was obtained. The shape of the same was nearly spherical.

### <Example 14>

The solvent was changed from diethylene glycol monobutyl ether in Example 1 to terpineol (Ter), and the resin was changed from poly(ethyl acrylate) to ethyl cellulose (EC, weight-average molecular weight: 190,000, produced by Dow Chemical Japan Limited) respectively. Specifically, a photovoltaic cell element 14 was produced by preparing a composition 14 for forming an electrode identically with Example 1, except that the contents of the respective components were changed to: 33.3 parts for the phosphorus-containing copper alloy particle, 22.8 parts for the tin particle, 22.2 parts for the nickel particle, 7.8 parts for the glass G01 particle, 13.5 parts for the terpineol (Ter), and 0.4 part for the ethyl cellulose (EC).

### <Examples 15 to 21>

Compositions 15 to 21for forming an electrode were prepared identically with Example 1, except that the phosphorus content, particle diameter (D50%) and content of the phosphorus-containing copper alloy particle; the component, particle diameter (D50%) and content of the tin-containing particle; the component, particle diameter (D50%), and content of the specific metal M-containing particle; the kind and content of the glass particle; the kind and content of the solvent, and the kind and content of the resin in Example 1 were changed as set forth in Table 1.

Then, using respectively the obtained compositions 15 to 21 for forming an electrode, photovoltaic cell elements 15 to 21 in which intended electrodes are formed were respectively produced identically with Example 1, except that the temperature and time of the thermal treatment were changed as set forth in Table 1.

### <Comparative Example 1>

A composition C1for forming an electrode was prepared identically with a composition 1 for forming an electrode in Example 1, except that for a silver particle (Ag) with a particle diameter (D50%) of 3.0 µm was used without using a phosphorus-containing copper alloy particle and a tin-containing particle as Example 1, and the components were changed to compose the composition set forth in Table 1.

A photovoltaic cell element C1 was produced identically with Example 1, except that the composition C1 for forming an electrode, which does not contain a phosphorus-containing copper alloy particle nor a tin-containing particle, was used.

### <Comparative Example 2>

A composition C2 for forming an electrode was prepared identically with a composition 1 for forming an electrode in Example 1, except that a copper particle (Cu) with a particle diameter (D50%) of 5.0 µm was used without using a phosphorus-containing copper alloy particle and a tin-containing particle, and the components were changed to compose the composition set forth in Table 1.

A photovoltaic cell element C2 was produced identically with Example 1, except that the composition C2 for forming an electrode which does not contain a phosphorus-containing copper alloy particle nor a tin-containing particle, was used.

### <Comparative Example 3>

A composition C3 for forming an electrode with the composition set forth in Table 1 was prepared using a phosphorus-containing copper alloy particle with a phosphorus content (phosphorus content: 1% by mass) different from that used in preparing a composition 1 for forming an electrode in Example 1, without using a tin-containing particle nor a nickel particle (Ni) as a specific metal M-containing particle.

A photovoltaic cell element C3 was produced identically with Comparative Example 1, except that the composition C3 for forming an electrode was used.

### <Comparative Example 4>

A composition C4 for forming an electrode with the composition set forth in Table 1 was prepared without using a tin-containing particle and a nickel particle (Ni) as a specific metal M-containing particle in preparing a composition 1 for forming an electrode in Example 1.

A photovoltaic cell element C4 was produced identically with Comparative Example 1, except that the composition C4 for forming an electrode was used.

### <Comparative Example 5>

A composition C5 for forming an electrode was prepare identically with Example 1 except that instead of a phosphorus-containing copper alloy particle in preparing a composition 1 for forming an electrode in Example 1, a copper particle (purity: 99.5%, particle diameter (D50%): 5.0 µm, content: 33.3 parts) was used, and the respective components were changed to the composition set forth in Table 1.

A photovoltaic cell element C5 was produced identically with Comparative Example 1, except that the composition C5 for forming an electrode was used.

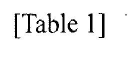

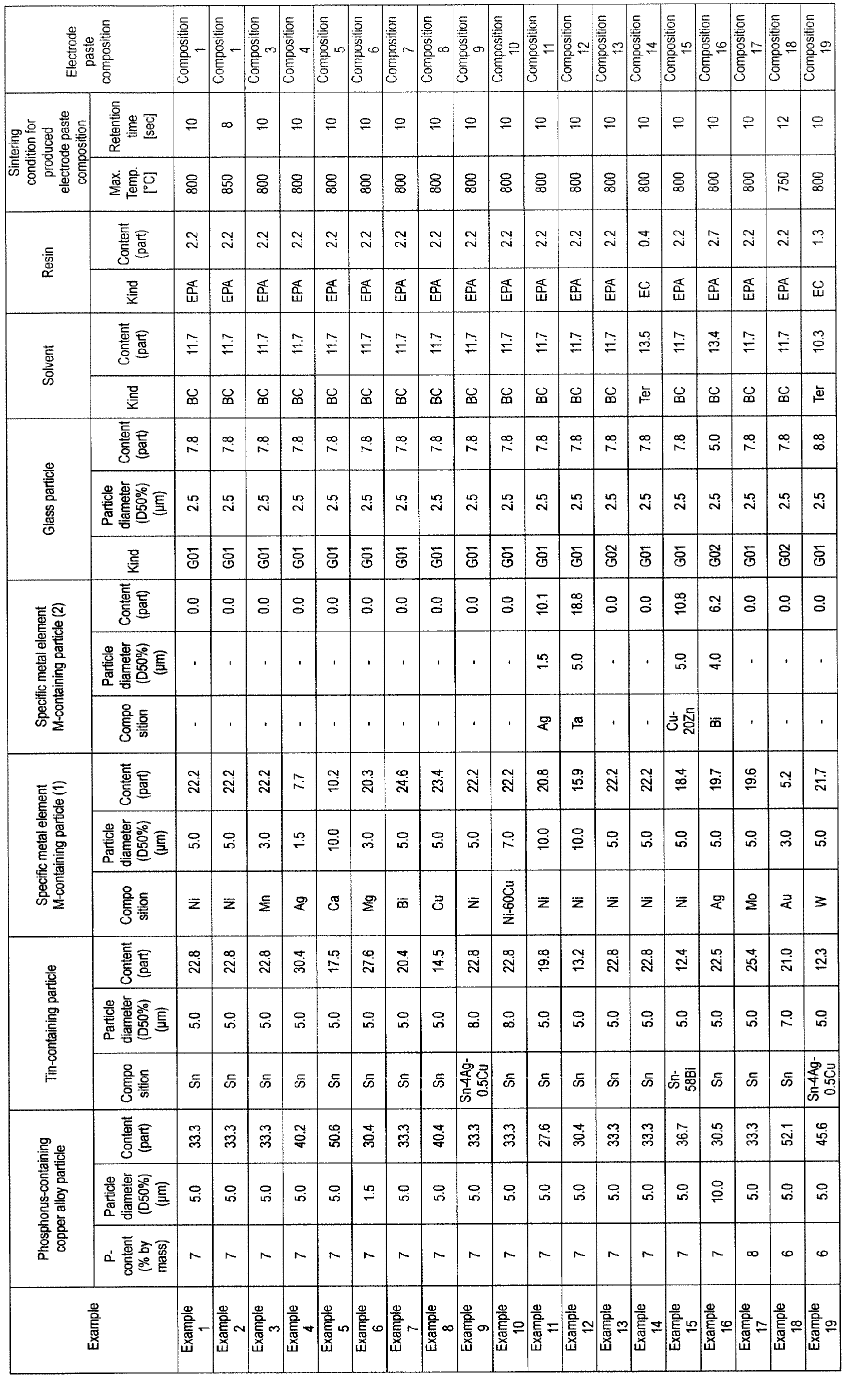

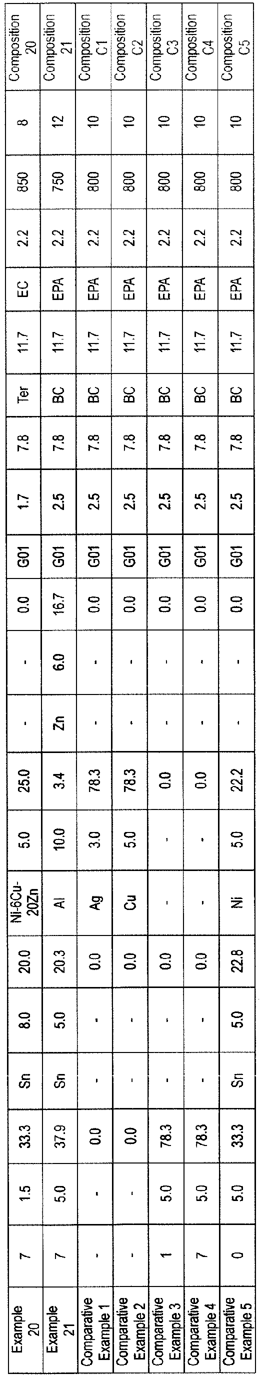

### <Evaluation>

An evaluation of a produced photovoltaic cell element was conducted by combining instruments for a solar light simulator WXS-155S-10 (produced by Wacom Electric Co., Ltd.) and a current-voltage (I-V) meter I-V CURVE TRACER MP-160 (produced by EKO Instrument). Jsc (short circuit current), Voc (open-circuit voltage), FF (Fill Factor) and Eff (conversion efficiency), which represent the electricity generation performance of a photovoltaic cell, were determined respectively by measurements in accordance with JIS-C-8912, JIS-C-8913, and JIS-C-8914. For a photovoltaic cell element with a structure having electrodes on both sides, the respective measured values are converted to relative values with respect to the measured values of Comparative Example 1 (photovoltaic cell element C1) as 100.0 and shown in Table 2. In the case of Comparative Example 2, the resistivity of an electrode prepared was too large, and the evaluation was not possible. This is presumably due to oxidation of the copper particle.

Further, a cross-section of a light receiving surface electrode formed by a thermal treatment (sintering) of a prepared composition for forming an electrode was observed with a scanning electron microscope MINISCOPE TM-1000 (produced by Hitachi, Ltd.) at an acceleration voltage of 15 kV, such that existence or nonexistence of a Cu-Sn alloy phase, an alloy phase (Cu-Sn-M alloy phase) composed of Cu, Sn and a specific metal element M, and a Sn-P-O glass phase in an electrode, and a formation site of a Sn-P-O glass phase were investigated. The results are also shown in Table 2.

**[Table 2]**

| Example | Electricity generation performance of photovoltaic cell | | | | Observation result on electrode cross-section tissue | | | |
|---|---|---|---|---|---|---|---|---|
| | Jsc (rel Val) Short circuit current | Voc (rel Val) Open-circuit voltage | F.F. (rel Val) Fill Factor | Eff (rel Val) Conversion efficiency | Cu-Sn alloy phase | Cu-Sn-M alloy phase | Sn-P-O glass phase | |
| | | | | | Existence | Existence | Existence | Existent site |
| Example 1 | 100.8 | 100.3 | 99.8 | 100.2 | No | Yes | Yes | Between Cu-Sn-Ni alloy phase and silicon substrate |
| Example 2 | 100.3 | 100.8 | 100.2 | 100.5 | No | Yes | Yes | Between Cu-Sn-Ni alloy phase and silicon substrate |
| Example 3 | 98.9 | 99.0 | 97.9 | 98.2 | No | Yes | Yes | Between Cu-Sn-Mn alloy phase and silicon substrate |
| Example 4 | 102.3 | 100.8 | 101.3 | 101.6 | No | Yes | Yes | Between Cu-Sn-Ag alloy phase and silicon substrate |
| Example 5 | 101.5 | 100.2 | 100.2 | 100.5 | No | Yes | Yes | Between Cu-Sn alloy phase and silicon substrate |
| Example 6 | 101.4 | 99.4 | 100.4 | 100.1 | No | Yes | Yes | Between Cu-Sn alloy phase and silicon substrate |
| Example 7 | 98.5 | 97.9 | 97.4 | 98.0 | No | Yes | Yes | Between Cu-Sn-Bi alloy phase and silicon substrate |
| Example 8 | 101.2 | 100.4 | 100.3 | 101.1 | No | Yes | Yes | Between Cu-Sn alloy phase and silicon substrate |
| Example 9 | 99.8 | 99.0 | 99.7 | 98.9 | No | Yes | Yes | Between Cu-Sn-Ni alloy phase and silicon substrate |
| Example 10 | 103.4 | 100.4 | 100.1 | 101.3 | No | Yes | Yes | Between Cu-Sn-Ni alloy phase and silicon substrate |
| Example 11 | 97.2 | 99.0 | 97.3 | 98.0 | No | Yes | Yes | Between Cu-Sn-Ni-Ag alloy phase and silicon substrate |
| Example 12 | 100.3 | 99.2 | 100.1 | 99.5 | No | Yes | Yes | Between Cu-Sn-Ni-Ta alloy phase and silicon substrate |
| Example 13 | 100.5 | 98.3 | 99.0 | 99.1 | No | Yes | Yes | Between Cu-Sn-Ni alloy phase and silicon substrate |
| Example 14 | 100.0 | 99.1 | 98.8 | 98.7 | No | Yes | Yes | Between Cu-Sn-Ni alloy phase and silicon substrate |
| Example 15 | 97.0 | 98.8 | 98.0 | 97.6 | No | Yes | Yes | Between Cu-Sn-Ni-Zn alloy phase and silicon substrate |
| Example 16 | 100.2 | 100.2 | 99.2 | 99.2 | No | Yes | Yes | Between Cu-Sn-Ag-Bi alloy phase and silicon substrate |
| Example 17 | 101.2 | 100.4 | 100.3 | 100.1 | No | Yes | Yes | Between Cu-Sn-Mo alloy phase and silicon substrate |
| Example 18 | 101.5 | 100.9 | 101.4 | 101.5 | No | Yes | Yes | Between Cu-Sn-Au alloy phase and silicon substrate |
| Example 19 | 101.3 | 100.2 | 99.9 | 95.4 | No | Yes | Yes | Between Cu-Sn-W alloy phase and silicon substrate |
| Example 20 | 100.5 | 100.1 | 99.2 | 98.5 | No | Yes | Yes | Between Cu-Sn-Ni alloy phase and silicon substrate |
| Example 21 | 97.6 | 98.0 | 97.2 | 97.0 | No | Yes | Yes | Between Cu-Sn-Al-Zn alloy phase and silicon substrate |
| Comparative Example 1 | 100.0 | 100.0 | 100.0 | 100.0 | - | - | - | - |
| Comparative Example 2 | - | - | - | - | No | No | No | - |
| Comparative Example 3 | 35.6 | 45.2 | 40.4 | 7.2 | No | No | No | - |
| Comparative Example 4 | 39.9 | 38.2 | 37.7 | 18.5 | Yes | No | No | - |
| Comparative Example 5 | 12.3 | 18.5 | 22.4 | 19.6 | No | No | No | - |

It is obvious from Table 2 that the electricity generation performance was deteriorated in Comparative Examples 3 to 5 compared to in Comparative Example 1. The reason behind the above is presumably, for example, as follows. Since in Comparative Example 4 a tin-containing particle is not contained, interdiffusion of silicon and copper occurred in a silicon substrate during a thermal treatment (sintering), so that pn junction characteristics in a substrate were conceivably deteriorated. Meanwhile, in Comparative Example 5, since a phosphorus-containing copper alloy particle was not used, and pure copper (phosphorus content: 0% by mass) was used, a copper particle was oxidized before the same reacted with a tin-containing particle during a thermal treatment (sintering), so that, conceivably, a Cu-Sn alloy phase was not formed and the resistance of an electrode increased.

On the other hand, the electricity generation performances of the photovoltaic cell elements produced in Examples 1 to 21 were almost as excellent as the measured value for the photovoltaic cell element in Comparative Example 1.

### [Explanation of References]

- 1: Semiconductor substrate
- 2: n⁺-type diffusion layer
- 3: Antireflection film
- 4: Light receiving surface electrode and Output power lead-out electrode
- 5: Back surface collector electrode
- 6: Back surface output power lead-out electrode
- 7: p⁺-type diffusion layer
- 8: Light receiving surface collector electrode
- 9: Through-hole electrode
- 10: Back electrode
- 11: Back electrode
- 12: n-type silicon substrate

## Claims

1. A composition for forming an electrode, the composition comprising a phosphorus-containing copper alloy particle, a tin-containing particle, a specific metal element M-containing particle, a glass particle, a solvent and a resin, wherein M represents at least one selected from the group consisting of Li, Be, Na, Mg, K, Ca, Rb, Sr, Cs, Ba, Fr, Ra, Sc, Ti, V, Cr, Mn, Fe, Co, Ni, Cu, Zn, Y, Zr, Nb, Mo, Tc, Ru, Pd, Ag, Cd, La, Ce, Pr, Nd, Pm, Sm, Eu, Gd, Tb, Dy, Ho, Er, Tm, Yb, Lu, Hf, Ta, W, Re, Os, Ir, Pt, Au, Hg, Al, Ga, Ge, In, Sb, Tl, Pb, Bi and Po.

2. The composition for forming an electrode according to claim 1, wherein a phosphorus content in the phosphorus-containing copper alloy particle is from 6.0% by mass to 8.0% by mass.

3. The composition for forming an electrode according to claim 1 or claim 2, wherein the tin-containing particle is at least one selected from the group consisting of a tin particle, and a tin alloy particle in which a content of tin is 1% by mass or more.

4. The composition for forming an electrode according to any one of claim 1 to claim 3, wherein the specific metal element M-containing particle is at least one selected from the group consisting of a particle of the specific metal element M, and an alloy particle of the specific metal element M in which a content of the specific metal element M is 5% by mass or more.

5. The composition for forming an electrode according to any one of claim 1 to claim 4, wherein a softening point of the glass particle is 650°C or less, and a crystallization initiation temperature of the glass particle is greater than 650°C.

6. The composition for forming an electrode according to any one of claim 1 to claim 5, wherein a content of the tin-containing particle is from 5% by mass to 70% by mass when a total content of the phosphorus-containing copper alloy particle, the tin-containing particle, and the specific metal element M-containing particle is designated as 100% by mass.

7. The composition for forming an electrode according to any one of claim 1 to claim 6, wherein a content of the specific metal element M-containing particle is from 4% by mass to 70% by mass when a total content of the phosphorus-containing copper alloy particle. the tin-containing particle, and the specific metal element M-containing particle is designated as 100% by mass.

8. The composition for forming an electrode according to any one of claim 1 to claim 7, wherein a total content of the phosphorus-containing copper alloy particle, the tin-containing particle, and the specific metal element M-containing particle is from 70% by mass to 94% by mass, a content of the glass particle is from 0.1% by mass to 10% by mass, and a total content of the solvent and the resin is from 3% by mass to 29.9% by mass.

9. A photovoltaic cell element comprising a silicon substrate, and an electrode which is a thermal-treated product of the composition for forming an electrode according to any one of claim 1 to claim 8 provided on the silicon substrate.

10. The photovoltaic cell element according to claim 9, wherein the electrode comprises an alloy phase containing Cu and Sn and a glass phase containing Sn, P and O.

11. The photovoltaic cell element according to claim 10, wherein the glass phase is placed between the alloy phase and the silicon substrate.

12. A photovoltaic cell comprising the photovoltaic cell element according to any one of claim 9 to claim 11, and a wiring material placed on the electrode of the photovoltaic cell element.

## Amended claims

### Amended claims under Art. 19.1 PCT

**1.** A composition for forming an electrode, the composition comprising a phosphorus-containing copper alloy particle, a tin-containing particle, a specific metal element M-containing particle, a glass particle, a solvent and a resin, wherein M represents at least one selected from the group consisting of Li, Be, Na, Mg, K, Ca, Rb, Sr, Cs, Ba, Fr, Ra, Sc, Ti, V, Cr, Mn, Fe, Co, Ni, Cu, Zn, Y, Zr, Nb, Mo, Tc, Ru, Pd, Ag, Cd, La, Ce, Pr, Nd, Pm, Sm, Eu, Gd, Tb, Dy, Ho, Er, Tm, Yb, Lu, Hf, Ta, W, Re, Os, Ir, Pt, Au, Hg, Al, Ga, Ge, In, Sb, Tl, Pb, Bi and Po.

**2.** The composition for forming an electrode according to claim 1, wherein a phosphorus content in the phosphorus-containing copper alloy particle is from 6.0% by mass to 8.0% by mass.

**3.** The composition for forming an electrode according to claim 1 or claim 2, wherein the tin-containing particle is at least one selected from the group consisting of a tin particle, and a tin alloy particle in which a content of tin is 1% by mass or more.

**4.** The composition for forming an electrode according to any one of claim 1 to claim 3, wherein the specific metal element M-containing particle is at least one selected from the group consisting of a particle of the specific metal element M, and an alloy particle of the specific metal element M in which a content of the specific metal element M is 5% by mass or more.

**5.** The composition for forming an electrode according to any one of claim 1 to claim 4, wherein a softening point of the glass particle is 650°C or less, and a crystallization initiation temperature of the glass particle is greater than 650°C.

**6.** The composition for forming an electrode according to any one of claim 1 to claim 5, wherein a content of the tin-containing particle is from 5% by mass to 70% by mass when a total content of the phosphorus-containing copper alloy particle, the tin-containing particle, and the specific metal element M-containing particle is designated as 100% by mass.

**7.** The composition for forming an electrode according to any one of claim 1 to claim 6, wherein a content of the specific metal element M-containing particle is from 4% by mass to 70% by mass when a total content of the phosphorus-containing copper alloy particle, the tin-containing particle, and the specific metal element M-containing particle is designated as 100% by mass.

**8.** The composition for forming an electrode according to any one of claim 1 to claim 7, wherein a total content of the phosphorus-containing copper alloy particle, the tin-containing particle, and the specific metal element M-containing particle is from 70% by mass to 94% by mass, a content of the glass particle is from 0.1% by mass to 10% by mass, and a total content of the solvent and the resin is from 3% by mass to 29.9% by mass.

**9.** A photovoltaic cell element comprising a silicon substrate, and an electrode which is a thermal-treated product of the composition for forming an electrode according to any one of claim 1 to claim 8 provided on the silicon substrate.

**10.** The photovoltaic cell element according to claim 9, wherein the electrode comprises an alloy phase containing Cu and Sn and a glass phase containing Sn, P and O.

**11.** The photovoltaic cell element according to claim 10, wherein the glass phase is placed between the alloy phase and the silicon substrate.

**12.** A photovoltaic cell comprising the photovoltaic cell element according to any one of claim 9 to claim 11, and a wiring material placed on the electrode of the photovoltaic cell element.

**13.** New) A photovoltaic cell element comprising a semiconductor substrate, and an electrode which is a thermal-treated product of the composition for forming an electrode according to any one of claim 1 to claim 8 provided on the semiconductor substrate.

**14.** New) The photovoltaic cell element according to claim 10, wherein the glass phase is placed between the alloy phase and the silicon substrate.

**15.** New) A method of producing a photovoltaic cell element, the method including:
applying the composition for forming an electrode according to any one of claim 1 to claim 8 on at least a portion of a semiconductor substrate; and
subjecting the composition to a thermal treatment to form an electrode.

**16.** New) A method of producing a photovoltaic cell, the method including:
providing a wiring material on the electrode of the photovoltaic cell element according to claim 15; and
sealing with a resin.
